(19) Europäisches Patentamt
European Patent Office
Office européen des brevets

(11) EP 4 764 693 A1

(12) **EUROPEAN PATENT APPLICATION**

(43) Date of publication:
24.06.2026 Bulletin 2026/26

(21) Application number: 25220891.3

(22) Date of filing: 04.12.2025

(51) International Patent Classification (IPC):
G03F 1/24 (2012.01)    G03F 1/32 (2012.01)
G03F 1/80 (2012.01)    G03F 1/48 (2012.01)

(52) Cooperative Patent Classification (CPC):
G03F 1/24; G03F 1/32; G03F 1/48; G03F 1/80

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 17.12.2024 JP 2024220486

(71) Applicant: SHIN-ETSU CHEMICAL CO., LTD.,
Chiyoda-ku,
Tokyo 1000005 (JP)

(72) Inventor: SAKURAI, Keisuke
Niigata, 9428601 (JP)

(74) Representative: Mewburn Ellis LLP
Aurora Building
Counterslip
Bristol BS1 6BX (GB)

(54) **REFLECTIVE PHOTOMASK, REFLECTIVE PHOTOMASK BLANK, AND METHOD FOR MANUFACTURING REFLECTIVE PHOTOMASK**

(57) A reflective photomask including a substrate, a multilayer reflection film, a protection film and a pattern of a light absorbing film is provided. The protection film is constituted of multiple layers including one A layer, one or more B layers, and one or more C layers, the A layer contains rhodium, and has a thickness of 0.5 to 2 nm, the B layer contains niobium, is free of rhodium, has a niobium content of not less than 10 at%, and has a thickness of 0.5 nm to 2 nm, the C layer contains molybdenum (Mo), is free of rhodium and niobium, has a molybdenum content of not less than 30 at%, and has a thickness of 0.5 nm to 2 nm, the A layer is in contact with the pattern of the light absorbing film, and one layer of the C layer(s) is in contact with the multilayer reflection film.

# FIG.1

EP 4 764 693 A1

**Description**

<u>TECHNICAL FIELD</u>

The present invention relates to a reflective photomask that is used in manufacturing semiconductor devices and others, a reflective photomask blank that is used as a material for manufacturing a reflective photomask, and a method for manufacturing a reflective photomask from a reflective photomask blank.

<u>BACKGROUND</u>

It is required that projection exposure has high pattern resolution in accordance with miniaturization of semiconductor devices, particularly, in accordance with high integration of large-scale integrated circuits. So, as a photomask, a phase shift photomask (a phase shift mask) has been developed as a means for improving the resolution of a transfer pattern. A principle of phase shift method is that, by adjusting so as to invert a phase of transmitted light that has been passed through an opening of a phase shift film of a photomask by about 180 degrees with respect to a phase of transmitted light that has been passed through the portion of the phase shift film adjacent to the opening, interference between the transmitted lights reduces a light intensity at the boundary of the opening and the portion adjacent to the opening. As a result, resolution and depth of focus of a transfer pattern are improved. A photomask utilizing this principle is generally called a phase shift photomask. The phase shift photomask in this case is a type of transmissive photomask that transmits exposure light.

A most common phase shift photomask blank, as a material for the phase shift photomask, that is used for manufacturing the phase shift photomask has a structure in which a phase shift film is laminated on a transparent substrate such as a glass substrate, and a film composed of a material containing chromium (Cr) is laminated on the phase shift film. The phase shift film usually has a phase shift of 175 to 185 degrees and a transmittance of about 6 to 30% with respect to exposure light, and a mainstream phase shift film is a film containing silicon (Si), particularly a film composed of a material containing molybdenum (Mo) and silicon (Si). Generally, the film composed of a material containing chromium (Cr) is adjusted so as to have a thickness that provides a desired optical density together with the phase shift film, and the film composed of a material containing chromium (Cr) is provided as a light-shielding film, and is also used as an etching mask in etching the phase shift film.

As a general method for manufacturing a phase shift photomask by patterning a phase shift film from a phase shift photomask blank in which a phase shift film that is composed of a material containing silicon (Si), and a light-shielding film that is composed of a material containing chromium (Cr) are formed in this order on a transparent substrate, the following method is exemplified. First, a resist film is formed on the light-shielding film composed of a material containing chromium (Cr) of the phase shift photomask blank, and a pattern of the resist film (a resist pattern) is formed by drawing a pattern onto the resist film by light or an electron beam, and developing. Next, the light-shielding film composed of a material containing chromium (Cr) is dry-etched with using the resist pattern as an etching mask, and a chlorine-based gas to form a pattern of the light-shielding film. Further, the phase shift film composed of a material containing silicon (Si) is dry-etched with using the pattern of the light-shielding film as an etching mask, and a fluorine-based gas to form a pattern of the phase shift film. Then, the resist pattern is removed, and the pattern of the light-shielding film is removed by dry etching using a chlorine-based gas.

In this case, the light-shielding film is left at the portion outside the portion in which the pattern of the phase shift film (a circuit pattern) is formed, and a light-shielding portion (light-shielding pattern) having an optical density of not less than 3 in the combination of the phase shift film and the light-shielding film is formed at the outer periphery portion of the phase shift photomask. This is to prevent irradiation of exposure light caused by leaking the exposure light at the outer periphery portion of the phase shift photomask from the portion located outside the circuit pattern to the resist film on a wafer for an adjacent chip in transferring the circuit pattern to the wafer by a wafer exposure apparatus. In a general method for forming such a light-shielding pattern, after forming the pattern of the phase shift film and removing the resist pattern, a resist film is anew formed, and a resist pattern that remains at the outer periphery portion of the light-shielding film is formed by drawing a pattern and developing. Then, the light-shielding film composed of a material containing chromium (Cr) is etched with using the resist pattern as an etching mask to left the light-shielding film at the outer periphery portion of the phase shift photomask.

A mainstream etching in a phase shift photomask blank that requires pattern formation with highly accurate is dry etching using gas plasma. Dry etching using a chlorine-based gas (chlorine-based dry etching) is used as dry etching for a film composed of a material containing chromium (Cr), and dry etching using a fluorine-based gas (fluorine-based dry etching) is used as dry etching for a film containing silicon (Si) and a film containing molybdenum and silicon. Particularly, it is known that, in dry etching for a film composed of a material containing chromium (Cr), chemical reactivity and etching rate are increased by applying a dry etching using a chlorine-based gas containing oxygen (O), in particular, an etching gas of chlorine gas ($Cl_2$ gas) mixed with 10 to 25 vol% of oxygen gas ($O_2$ gas).

According to miniaturization of circuit patterns, a circuit pattern of the phase shift photomask also requires a technique for fine pattern formation. Particularly, assist patterns of line patterns, which assist resolution of main patterns of the phase shift photomask, are needed to be formed smaller than the main patterns so as not to be transferred to a wafer when circuit patterns are transferred to the wafer by a wafer exposure apparatus. In a phase shift photomask of a generation in which a half pitch of line and space patterns on the wafer is 10 nm, a line width for the assist patterns of the line patterns in a circuit on the phase shift photomask is required to be about 40 nm.

A chemically amplified resist, which can form fine patterns, consists of a base resin, an acid generator, a surfactant and others, and can be applied to many reactions in which the acid generated by exposure acts as a catalyst. Thus, the chemically amplified resist can have high sensitivity. By using the chemically amplified resist, it possible to form a mask pattern such as a fine pattern of the phase shift film that has a line width of 0.1 $\mu$m or less. The resist is applied onto a photomask blank by spin coating using a resist coater.

A typical thickness of a resist film used in manufacturing a phase shift photomask is about 100 to 150 nm. However, it is difficult to form a finer assist pattern on a phase shift photomask by such thickness. This is because when a thick resist film formed on a film composed of a material containing chromium (Cr) is used, a resist pattern having a high high-width ratio (aspect ratio) is formed in the case of a narrow linewidth for forming an assist pattern, and in a development process for forming the resist pattern, the resist pattern collapses due to impact by a development solution or impact by pure water in rinsing.

To reduce the impact by a development solution or the impact by pure water in rinsing, it is required that a resist film is formed thinner under the consideration for reducing the high-width ratio (aspect ratio) of the resist pattern. However, in the case that the resist film is thinned, when the resist film disappears during dry etching of a film composed of a material containing chromium (Cr), defects such as pinholes are formed in the film composed of a material containing chromium (Cr). If a film composed of a material containing silicon (Si) is dry-etched with using, as an etching mask, a pattern of the film composed of a material containing chromium (Cr) and having pinholes or other defects, a plasma reaches the film composed of a material containing silicon (Si) through the pinholes during etching of the film composed of a material containing silicon (Si), and pinhole defects are formed also in the film composed of a material containing silicon (Si). In this case, it is hard to form a pattern of the film composed of material containing silicon (Si) (ex. a phase shift film) without defects, and a good photomask (ex. a phase shift photomask) cannot be manufactured.

To solve this problem, a method in which a film composed of a material containing silicon (Si) is provided on the film composed of a material containing chromium (Cr), and is used as a hard mask has been considered. In this case, the film composed of a material containing silicon (Si) is a thin film having a thickness of 5 to 15 nm, and the resist film formed on the film composed of a material containing silicon (Si) can be thinned to 80 to 110 nm.

When a film composed of a material containing chromium (Cr) is dry-etched with using a chlorine-based gas containing oxygen (O), it is necessary to perform the dry etching for a time that includes a clear time until the film composed of a material containing chromium (Cr) disappears, and a time of 100 to 300% of the clear time for over etching. This is because the dry etching using a chlorine-based gas containing oxygen (O) is an isotropic etching dominated by chemical components, when the dry etching is performed for only the clear time, a flared shape at the boundary with the film composed of a material containing silicon (Si) is formed, result in an insufficient shape in the pattern of the film composed of a material containing chromium (Cr). Thus, a desired pattern width is not formed stably.

Further, dry etching using a chlorine-based gas containing oxygen (O) is an isotropic etching dominated by chemical components, and therefore a plasma of the chlorine-based gas containing oxygen (O) moves vertical direction and horizontal direction relative to the main surface of a substrate, causing side etching of the pattern in the film composed of a material containing chromium (Cr). To obtain an equivalent amount of side etching across the entire main surface of a photomask for making a uniform critical dimension (CD), which is a pattern line width, across the entire main surface of the photomask, a long over etching time is required until the amount of side etching saturates across the entire main surface of the photomask (until the side etching stops and the amount of the side etching is constantly maintained).

On the other hand, dry etching using a fluorine-based gas is used for dry etching of the film composed of a material containing silicon (Si). When the film composed of a material containing silicon (Si) is dry-etched with using a fluorine-based gas, the dry etching is performed for a time that includes a clear time until the film composed of a material containing silicon (Si) disappears, and a time of not more than about 20% of the clear time (ex. a short time of 1 to 6 seconds) for over etching.

The reason why the over etching can be performed shortly when the film composed of a material containing silicon (Si) is dry-etched with using a fluorine-based gas is that the dry etching using a fluorine-based gas is anisotropic etching dominated by physical components, and therefore the flared shape is not formed in the pattern of the film composed of a material containing silicon (Si) at the boundary with the film composed of a material containing chromium (Cr). Further, a plasma of the fluorine-based gas moves vertical direction relative to the main surface of a substrate, faithfully duplicating the CD of the resist pattern in the pattern of the film composed of a material containing silicon (Si).

Dry etching using fluorine-based gases is anisotropic etching dominated by physical components, so a loss amount of the resist during the dry etching is generally larger than that during dry etching using chlorine-based gases containing oxygen (O). Therefore, a resist film used for forming the pattern of the film composed of a material containing silicon (Si) must be relatively thick. On the other hand, the film composed of a material containing silicon (Si) functions as an etching mask when the film composed of a material containing chromium (Cr) is dry-etched with using a chlorine-based gas containing oxygen (O). Since the film composed of a material containing silicon (Si) has sufficient etching resistance to dry etching using a chlorine-based gas containing oxygen (O), the film composed of a material containing silicon (Si) as the hard mask film can be formed as a relatively thin film. A thinner film composed of a material containing silicon (Si) shortens the time required for the dry etching using a fluorine-based gas to the film composed of a material containing silicon (Si). As a result, the resist film required to form the pattern of the film composed of a material containing silicon (Si) can also be thinner.

Furthermore, in higher pattern resolution that has been recently required for projection exposure, it has been difficult to obtain a desired pattern resolution even when a transmission type phase shift photomask is used. Therefore, for the logic 7 nm generation and later, EUV lithography using light in extreme ultraviolet range (EUV light) as the exposure light has come to be used.

The light in extreme ultraviolet range is easily absorbed by all materials, and transmission lithography such as conventional photolithography using ArF excimer laser light cannot be used. Therefore, a reflective optical system is used in the EUV lithography. The light in extreme ultraviolet range has a wavelength of 13 to 14 nm is used in the EUV lithography, while the conventional ArF excimer laser light has a wavelength of is 193 nm. Therefore, compared to the photolithography using the conventional ArF excimer laser light, the exposure wavelength is shorter, and finer patterns in a photomask can be transferred.

A photomask used in EUV lithography is a reflective photomask in which the exposure light is reflected by the photomask, and generally has a structure in which a reflection film that reflects light in extreme ultraviolet range, a protection film for protecting the reflection film, and a pattern of a light absorbing film that absorbs the light in extreme ultraviolet range in this order on a substrate such as a glass substrate. As the reflection film, a multilayer reflection film in which low refractive index layers and high refractive index layers are alternately stacked so as to increase reflectance when the light in extreme ultraviolet range is irradiated onto the surface of the reflection film is used. Usually, for the multilayer reflection film, a molybdenum (Mo) layer and a silicon (Si) layer are used as the low refractive index layer, and the high refractive index layer, respectively. As the protection film, a ruthenium (Ru) film is usually used. On the other hand, a material having a high absorption coefficient with respect to the light in extreme ultraviolet range, in particular, a material containing, for example, chromium (Cr) or tantalum (Ta), as a main component, is used for the light absorbing film. In early-generation EUV lithography, a binary-type reflective photomask in which light is not reflected by the light absorbing film is used.

As a general method for manufacturing a reflective photomask by patterning a light absorbing film from a reflective photomask blank in which a reflection film that reflects light in extreme ultraviolet range, a protection film for protecting the reflection film, and a light absorbing film that absorbs the light in extreme ultraviolet range are formed in this order on a substrate, in particular, the following method is exemplified. First, a resist film is formed on the light absorbing film, a pattern is drawn onto the resist film by light or an electron beam, and developed to form a resist pattern. Next, the light absorbing film is dry-etched with using the resist pattern as an etching mask to form a pattern of the light absorbing film, and then the resist pattern is removed.

Citation List

Patent Document 1: JP 2022-24617 A
Patent Document 2: JP 2023-86742 A
Patent Document 3: WO 2023/127799 A1

SUMMARY OF THE INVENTION

In EUV lithography, for the logic 3 nm generation and later, a reflective photomask (reflective phase shift photomask) that includes a pattern of a light absorbing film having a phase shift function is used to form a finer pattern on a wafer. By using the reflective phase shift photomask, higher wafer transfer characteristics can be obtained compared to a binary-type reflective photomask. The wafer transfer characteristics can be expressed by NILS (Normalized Image Log Slope), which corresponds to contrast of light intensity transferred to a wafer, and the NILS can be calculated by the following expression:

$$NILS = (dI/dx)/(W \times Ith),$$

wherein W is a desired pattern dimension, Ith is a threshold of light intensity providing W, and dI/dx is a gradient of aerial image. When the NILS value is large, the optical image is steep, improving dimensional controllability of a resist pattern on the wafer. Therefore, to form a finer pattern on the wafer, a large NILS value is effective, and the reflective phase shift photomask, which can provide a larger NILS value compared to the binary-type reflective photomask, is used.

In EUV lithography using a reflective phase shift photomask, when sizes (pitches) of line and space of a line and space pattern on a wafer is 10 to 20 nm, the optimal focus value varies depending on the sizes (pitches) of line and space. When a single device circuit pattern has a mixture of line and space patterns that include lines and spaces having different sizes (pitches), to form a good device circuit pattern in each of the line and space patterns, device circuit patterns including good line and apace patterns can be formed by a light absorbing film having a phase shift function and a reflectance of about 5% with respect to exposure light since such a film has a small difference in optimal focus values between line and space patterns that include lines and spaces having different sizes (pitches).

Further, a light absorbing film is necessary to have a thickness enough to partially absorb exposure light and have a predetermined reflectance. In a reflective photomask, the exposure light is incident on the reflective photomask at an angle and is reflected at an angle. A shadowing effect in which the exposure light is blocked by the light absorbing film when the exposure light is incident and is reflected, notably affects a thick light absorbing film. Therefore, to reduce the shadowing effect, a thinner light absorbing film having a predetermined reflectance is advantageous.

In a reflective photomask that is necessary for EUV lithography, an assist pattern for the line and space pattern, which assists resolution of a main pattern, has been required to be even smaller depending on miniaturization of the main pattern, and the line width of the assist patterns needs to be reduced to around 30 nm, particularly around 25 nm. Therefore, compared to a conventional transmissive phase shift photomask blank, a reflective photomask blank requires an even thinner resist film. In the reflective photomask, to form the assist pattern for a line and space pattern having a width of around 30 nm, particularly around 25 nm, a resist film having a thickness of not more than 80 nm is required.

In EUV lithography, an optical system having a numerical aperture (NA) of 0.55 altered from 0.33 in an exposure system is used to form a finer pattern on a wafer. In this case, in a reflective photomask, an assist pattern, which assists resolution of a main pattern in a line and space pattern, has been required to be even smaller depending on miniaturization of the main pattern, and the line width of the assist pattern is required to be reduced to around 25 nm, particularly around 20 nm. Therefore, to manufacture a reflective photomask for use in the exposure system having a numerical aperture of 0.55, it is necessary to further thin the resist film used in the reflective photomask blank.

Furthermore, even when the assist pattern of the line and space pattern is fine, in the case that the fine line pattern disappears during a process of manufacturing a reflective photomask from a reflective photomask blank, the desired pattern cannot be obtained. Therefore, it is also necessary to improve a resolution limit.

For example, JP 2022-24617 A (Patent Document 1) discloses a reflective mask blank for EUV lithography in which a multilayer reflection film that reflects EUV light and a phase shift film that shifts a phase of EUV light are formed in that order on a substrate. The document also discloses that the phase shift film has a layer containing ruthenium (Ru) and at least one selected from the group consisting of oxygen (O) and nitrogen (N), and that, in diffraction peaks derived from the phase shift film that are observed between $2\theta$: 20° and 50° by out-of-plane XRD method, the phase shift film has a full width at half maximum (FWHM) of the most intense peak of not less than 1.0°.

JP 2022-24617 A (Patent Document 1) discloses that the layer containing ruthenium (Ru) and at least one selected from the group consisting of oxygen (O) and nitrogen (N) contains the elements in the range of a total content of Ru and element (X) of 40 to 99 at% and an O content of 1 to 60 at%, a total content of Ru and element (X) of 30 to 98 at%, an O content of 1 to 69 at% and a N content of 1 to 69 at%, or a total content of Ru and element (X) of 30 to 90 at% and a N content of 10 to 70 at%, and in the range of a Ru:X ratio of 20:1 to 1:5 (at%). Further, as the element (X), chromium (Cr), tantalum (Ta), titanium (Ti), rhenium (Re), tungsten (W), bismuth (Bi), manganese (Mn), platinum (Pt), copper (Cu), iridium (Ir) and vanadium (V) are disclosed.

JP 2022-24617 A (Patent Document 1) discloses that the phase shift film has a phase shift of is 150 to 250 degrees and a relative reflectance of 2 to 37%. Further, JP 2022-24617 A (Patent Document 1) discloses, as the phase shift film having a reflectance of about 5% with respect to exposure light, a RuReON film (Ru:Re:O:N=16:71:12:11 (at%), Example 11) having a phase shift of 216 degrees and a relative reflectance of 6.1%, and a RuCrO film (Ru:Cr:O=20:30:50 (at%), Example 15) having a phase shift of 216 degrees, a relative reflectance of 7.3%, and a thickness of 40 nm.

However, each of the phase shift films does not have a thickness sufficiently reduced. Furthermore, when a pattern of the light absorbing film formed in a reflective photomask is corrected, a film containing ruthenium (Ru) can usually be etched by dry etching using a fluorine-based gas activated by an electron beam, however, a film containing a large amount of chromium (Cr) or rhenium (Re) cannot be effectively etched by the dry etching using a fluorine-based gas activated by an electron beam.

JP 2023-86742 A (Patent Document 2) discloses a reflective mask blank for EUV lithography in which a multilayer reflection film that reflects EUV light and a phase shift film that shifts a phase of the EUV light are formed in that order on a substrate. Further, the document also discloses that the phase shift film has a surface roughness (rms) of not more than 0.50 nm, the phase shift film includes a layer (1) containing ruthenium (Ru) and nitrogen (N) and having an absolute value of film stress of not more than 1000 MPa, the phase shift film includes a layer (2) containing an element (X), the layer (2) may contain Ru, and at least one of O and N with a Ru:X ratio of 20:1 to 1:5 (at %). Furthermore, as the element (X), chromium (Cr), tantalum (Ta), titanium (Ti), rhenium (Re), tungsten (W), bismuth (Bi), manganese (Mn), platinum (Pt), copper (Cu), iridium (Ir) and vanadium (V) are disclosed.

JP 2023-86742 A (Patent Document 2) discloses that the phase shift film has a phase shift of is 150 to 250 degrees and a relative reflectance of 2 to 37%, however, does not disclose any concrete phase shift film having a reflectance of about 5% with respect to exposure light. Further, the layer (1) is not a layer containing Ru, and the document does not disclose any concrete layer (2) containing ruthenium (Ru) together with the element (X). Particularly, when the phase shift film includes the layer (2), the phase shift film has a two-layer structure consisting of the layer (1) not containing element (X) and the layer (2) containing element (X).

In this case, when a pattern of the light absorbing film formed in the reflective photomask is corrected, the layer (2) cannot be effectively etched by the dry etching using a fluorine-based gas activated by an electron beam in the case of some kinds of the element (X) which is a metal element. Therefore, different etching gases must be used for etching the layer (1) and the layer (2), respectively, and correction is performed by multiple types of etching, and the multiple types of etching significantly reduce possibility of success of correcting the pattern of the light absorbing film compared to correction by a single type of etching.

On the other hand, even when the layer (2) can be etched by the dry etching using a fluorine-based gas activated by an electron beam, the layer (1) not containing the element (X) and the layer (2) containing the element (X), particularly the layer (2) containing a relatively large amount of the element (X) have different etching characteristics. Therefore, it is difficult to control the etching in correction of the pattern of the light absorbing film, and the correction of the pattern of the light absorbing film is not easy.

Furthermore, in a wafer exposure apparatus using exposure light being light in extreme ultraviolet range, the light in extreme ultraviolet range emitted from a light source is irradiated onto a reflective photomask via multiple mirrors, and finally reaches a wafer. If the mirrors that reflect the light in extreme ultraviolet range or the reflective photomask is contaminated with foreign matters, an amount of reflected light in extreme ultraviolet range decreases, and a desired pattern cannot be formed on the wafer. Particularly, accumulation of carbon-based foreign matters is raised as a problem, and to solve the problem, hydrogen gas is introduced into the wafer exposure apparatus.

However, when hydrogen gas is irradiated with light in extreme ultraviolet range, hydrogen plasma containing hydrogen ions or hydrogen radicals is generated, and the reflective photomask is exposed to the hydrogen plasma. When the generated hydrogen plasma collides with the light absorbing film or the protection film, the hydrogen plasma penetrates the pattern of the light absorbing film of the reflective photomask and further reaches inside of the protection film or penetrates the protection film. As a result, hydrogen gas is generated at the interface between the protection film and the multilayer reflection film or inside the protection film. In this case, if hydrogen gas forms bubbles and accumulates inside the protection film or at the interface between the protection film and the multilayer reflection film, there is such a problem that the protection film expands or is lifted up at the portion expanded by the hydrogen gas and the pattern of the light absorbing film is also lifted up and deformed, resulting in defects. This defect is commonly called a blister defect. When the blister defect occurs in a reflective photomask, reflectance is locally fluctuated, and further, the protection film and the pattern of light absorbing film are destroyed. As a result, a desired pattern cannot be formed on the wafer.

In a reflective photomask required for EUV lithography, in some cases, an assist pattern of a line and space pattern, which assists resolution of a main pattern, is required to have a further reduced width of around 20 nm according to miniaturization of the main pattern. Therefore, in a reflective photomask blank used in an exposure apparatus having a numerical aperture of 0.55, a thinner resist is required, and it is also necessary to reduce deterioration in resolution caused by loss of a fine line pattern in a process of dry etching.

To improve resolution of the light absorbing film, a hard mask film is formed in contact with the light absorbing film of a reflective photomask blank. The hard mask film is a thin film having a thickness of around 10 nm, and can reduce the resist film formed on and in contact with the hard mask film to a thickness even thinner than 80 nm. In this case, even when a resist pattern having a narrow line width for forming assist pattern is used, the resist pattern has a low height-width ratio (low aspect ratio), so, in a developing process for forming the resist pattern, the resist pattern is prevented from collapsing due to impact by a development solution or impact by pure water in rinsing, thereby improving the resolution.

On the other hand, when the hard mask film is used, in a process of manufacturing a reflective photomask from a reflective photomask blank, the protection film is exposed to plasma of dry etching in finally removing the hard mask film. Furthermore, when the light absorbing film is patterned, the protection film is also exposed to plasma of dry etching in the final stage (over etching) of the patterning. Therefore, compared to the hard mask film and the light absorbing film, it is necessary to form the protection film composed of a material that is resistant to each of dry etchings applying for them.

WO 2023/127799 A1 (Patent Document 3) discloses a protection film including an upper layer consisting of a rhodium-based material containing Rh as a main component that contains Rh, or Rh and at least one element selected from the group consisting of N, O, C, B, Ru, Nb, Mo, Ta, Ir, Pd, Zr, and Ti, and a lower layer containing at least one element selected from the group consisting of Ru, Nb, Mo, Zr, Y, C, and B. However, hydrogen plasma containing hydrogen ions or hydrogen radicals easily penetrates ruthenium (Ru) and rhodium (Rh), which are conventionally used as materials for the protection film, thus, a protection film that is less likely to cause a blister defects is desired.

Furthermore, if the protection film blocks exposure light incident on the multilayer reflection film and light reflected from the multilayer reflection film, resulting in decrease of reflectance from the multilayer reflection film and decrease of an amount of reflected light that can be effectively used for wafer exposure.

The present invention has been made to solve the above problems. A first object of the present invention is to provide a reflective photomask including a protection film that is less likely to cause a blister defect in an environment in which light in extreme ultraviolet range irradiates in the presence of hydrogen, and is less likely to cause decrease of reflectance of exposure light from the multilayer reflection film, and a reflective photomask blank that can be provided to manufacture such a reflective photomask. A second object of the present invention is to provide a method for manufacturing a reflective photomask from a reflective photomask blank.

With respect to a protection film in a reflective photomask blank and a reflective photomask, the inventor has made earnestly studies to solve the above problems. As a result, the inventor found that the above problems can be solved by a protection film that is constituted of multiple layers having predetermined thicknesses, includes one A layer containing rhodium (Rh), one or two or more B layer containing niobium (Nb) at a content of not less than a predetermined content and being free of rhodium (Rh), and one or two or more C layer containing molybdenum (Mo) at a content of not less than a predetermined content and being free of rhodium (Rh) and niobium (Nb), and has a predetermined arrangement of the layers. Further, with respect to a reflective photomask blank for manufacturing a reflective photomask, the inventor has made earnestly studies to solve the above problems. As a result, the inventor found that the above problems can be solved by a reflective photomask blank including a hard mask film formed in contact with the light absorbing film.

Furthermore, with respect to a light absorbing film in a reflective photomask blank and a reflective photomask, the inventor has made earnestly studies to solve the above problems. As a result, the inventor found that a reflective photomask including a thinner light absorbing film that has high wafer transfer characteristics (a high NILS value), has a reflectance of approximately 5% which provides small difference in optimal focus values of line and space patterns having different sizes (pitches), can be removed by etching using fluorine-based gas in whole, is easily corrected in its pattern, and is minimally affected by shadowing effect can be provided by a light absorbing film constituted of a single layer or multiple layers that are composed of a material containing ruthenium (Ru) and platinum (Pt).

In one aspect, the invention provides a reflective photomask including

a substrate,
a multilayer reflection film that is formed on the substrate and reflects exposure light being light in extreme ultraviolet range,
a protection film that is formed on and in contact with the multilayer reflection film to protect the multilayer reflection film, and
a pattern of a light absorbing film that is formed on and in contact with the protection film, and absorbs the exposure light, wherein

the protection film is constituted of multiple layers including one A layer, one or two or more B layers, and one or two or more C layers,
the A layer of the protection film contains rhodium (Rh), and has a thickness of not less than 0.5 nm and not more than 2 nm,
the B layer of the protection film contains niobium (Nb), is free of rhodium (Rh), has a niobium (Nb) content of not less than 10 at%, and has a thickness of not less than 0.5 nm and not more than 2 nm,
the C layer of the protection film contains molybdenum (Mo), or molybdenum (Mo) and at least one selected from the group consisting of ruthenium (Ru), oxygen (O) and nitrogen (N), is free of rhodium (Rh) and niobium (Nb), has a molybdenum (Mo) content of not less than 30 at%, and has a thickness of not less than 0.5 nm and not more than 2 nm,
the A layer is in contact with the pattern of the light absorbing film, and
one layer of the C layer(s) is in contact with the multilayer reflection film.

Preferably, the protection film is constituted of multiple layers consisting of the A layer, the B layer(s) and the C layer(s).

Preferably, the protection film is constituted of multiple layers consisting of three layers of, from the side remote from the substrate, the A layer, the B layer and the C layer, or multiple layers consisting of five layers of, from the side remote from the substrate, the A layer, the B layer, the C layer, the B layer and the C layer.

Preferably, the light absorbing film is constituted of a single layer or multiple layers,

the single layer or each layer of the multiple layers is composed of a material that contains ruthenium (Ru) and platinum (Pt), and has a ruthenium (Ru) content of not less than 30 at% and not more than 70 at%, a platinum (Pt) content of not less than 30 at% and not more than 70 at%, and a total content of ruthenium (Ru) and platinum (Pt) of not less than 96 at%,

the light absorbing film has a thickness of not less than 32 nm and not more than 38 nm, and

the light absorbing film has a reflectance of not less than 1% and not more than 8% with respect to the exposure light, and a phase shift of not less than 190 degrees and not more than 240 degrees with respect to the exposure light.

In another aspect, the invention provides a reflective photomask blank including

a substrate,
a multilayer reflection film that is formed on the substrate and reflects exposure light being light in extreme ultraviolet range,
a protection film that is formed on and in contact with the multilayer reflection film to protect the multilayer reflection film,
a light absorbing film that is formed on and in contact with the protection film, and absorbs the exposure light, and
a hard mask film that is formed on and in contact with the light absorbing film, wherein

the protection film is constituted of multiple layers including one A layer, one or two or more B layers, and one or two or more C layers,
the A layer of the protection film contains rhodium (Rh), and has a thickness of not less than 0.5 nm and not more than 2 nm,
the B layer of the protection film contains niobium (Nb), is free of rhodium (Rh), has a niobium (Nb) content of not less than 10 at%, and has a thickness of not less than 0.5 nm and not more than 2 nm,
the C layer of the protection film contains molybdenum (Mo), or molybdenum (Mo) and at least one selected from the group consisting of ruthenium (Ru), oxygen (O) and nitrogen (N), is free of rhodium (Rh) and niobium (Nb), has a molybdenum (Mo) content of not less than 30 at%, and has a thickness of not less than 0.5 nm and not more than 2 nm,
the A layer is in contact with the light absorbing film, and
one layer of the C layer(s) is in contact with the multilayer reflection film.

Preferably, the protection film is constituted of multiple layers consisting of the A layer, the B layer(s) and the C layer(s).

Preferably, the protection film is constituted of multiple layers consisting of three layers of, from the side remote from the substrate, the A layer, the B layer and the C layer, or multiple layers consisting of five layers of, from the side remote from the substrate, the A layer, the B layer, the C layer, the B layer and the C layer.

Preferably, the light absorbing film is constituted of a single layer or multiple layers,

the single layer or each layer of the multiple layers is composed of a material that contains ruthenium (Ru) and platinum (Pt), and has a ruthenium (Ru) content of not less than 30 at% and not more than 70 at%, a platinum (Pt) content of not less than 30 at% and not more than 70 at%, and a total content of ruthenium (Ru) and platinum (Pt) of not less than 96 at%,
the light absorbing film has a thickness of not less than 32 nm and not more than 38 nm, and
the light absorbing film has a reflectance of not less than 1% and not more than 8% with respect to the exposure light, and a phase shift of not less than 190 degrees and not more than 240 degrees with respect to the exposure light.

Preferably, the hard mask film includes a first layer that is in contact with the light absorbing film, and functions as an etching mask in patterning the light absorbing film by dry etching, and the first layer of the hard mask film is composed of a material that is resistant to dry etching using a fluorine-based gas, and is removal by dry etching using a chlorine-based gas.

Preferably, the hard mask film includes a second layer that is in contact with the first layer of the hard mask film, and functions as an etching mask in patterning the first layer of the hard mask film by dry etching, and the second layer of the hard mask film is composed of a material that is resistant to dry etching using a chlorine-based gas, and is removal by dry etching using a fluorine-based gas.

In another aspect, the invention provides a method for manufacturing the reflective photomask from the reflective photomask blank wherein
the method includes the steps of:

(A1) forming a resist film in contact with the first layer of the hard mask film at the side remote from the substrate,

(B) patterning the resist film to form a resist pattern,

(C1) patterning the first layer of the hard mask film to form a pattern of the first layer of the hard mask film by dry etching using a chlorine-based gas and the resist pattern as an etching mask,

(D) removing the resist pattern,

(F1) patterning the light absorbing film to form a pattern of the light absorbing film by dry etching using a fluorine-based gas and the pattern of the first layer of the hard mask film as an etching mask, and

(G1) removing the pattern of the first layer of the hard mask film by dry etching using a chlorine-based gas.

In the other aspect, the invention provides a method for manufacturing the reflective photomask from the reflective photomask blank wherein
the method includes the steps of:

(A2) forming a resist film in contact with the second layer of the hard mask film at the side remote from the substrate,

(B) patterning the resist film to form a resist pattern,

(C2) patterning the second layer of the hard mask film to form a pattern of the second layer of the hard mask film by dry etching using a fluorine-based gas and the resist pattern as an etching mask,

(D) removing the resist pattern,

(E2) patterning the first layer of the hard mask film to form a pattern of the first layer of the hard mask film by dry etching using a chlorine-based gas and the pattern of the second layer of the hard mask film as an etching mask,

(F2) patterning the light absorbing film to form a pattern of the light absorbing film by dry etching using a fluorine-based gas and the pattern of the first layer of the hard mask film as an etching mask with removing the pattern of the second layer of the hard mask film, and

(G2) removing the pattern of the first layer of the hard mask film by dry etching using a chlorine-based gas.

ADVANTAGEOUS EFFECTS

According to the invention, a reflective photomask including a protection film that is less likely to cause a blister defect in an environment in which light in extreme ultraviolet range irradiates in the presence of hydrogen, and is less likely to cause decrease of reflectance of exposure light from the multilayer reflection film can be provided. Further, according to the invention, a reflective photomask blank that enables to use a thinner resist film in forming a pattern of a light absorbing film and has an improved resolution limit in forming the pattern of the light absorbing film.

Particularly, in the case that the light absorbing film is composed of a material containing ruthenium (Ru) and platinum (Pt), a reflective photomask including a thinner light absorbing film that has high wafer transfer characteristics (a high NILS value), has a reflectance of approximately 5% which provides small difference in optimal focus values of line and space patterns having different sizes (pitches), can be removed by etching using fluorine-based gas in whole, is easily corrected in its pattern, and is minimally affected by shadowing effect can be provided.

BRIEF DESCRIPTION OF THE DRAWINGS

FIG. 1 is a cross-sectional view illustrating an example of a first embodiment of a reflective photomask blank of the invention.

FIG. 2 is a cross-sectional view illustrating an example of a second embodiment of a reflective photomask blank of the invention.

FIG. 3 is a cross-sectional view illustrating an example of a third embodiment of a reflective photomask blank of the invention.

FIG. 4 is a cross-sectional view illustrating an example of a fourth embodiment of a reflective photomask blank of the invention.

FIG. 5 is a cross-sectional view illustrating an example of a reflective photomask of the invention.

FIGS. 6A to 6F are cross-sectional views illustrating an example of steps for manufacturing a reflective photomask from a reflective photomask blank of the first or third embodiment of the of the invention.

FIGS. 7A to 7G are cross-sectional views illustrating an example of steps for manufacturing a reflective photomask from a reflective photomask blank of the second or fourth embodiment of the invention.

FURTHER EXPLANATIONS; OPTIONS AND PREFERENCES

A reflective photomask of the invention includes a substrate, a multilayer reflection film that is formed on the substrate, a protection film that is formed on the multilayer reflection film, and a pattern of a light absorbing film that is formed on the protection film. A reflective photomask blank of the invention includes a substrate, a multilayer reflection film that is formed on the substrate, a protection film that is formed on the multilayer reflection film, a light absorbing film that is formed on the protection film, and a hard mask film that is formed on the light absorbing film. The protection film is constituted of multiple layers including an A layer, a B layer and a C layer. The hard mask film preferably includes a first layer that functions as an etching mask in patterning the light absorbing film by dry etching. Further, the hard mask film more preferably includes a second layer that functions as an etching mask in patterning the first layer of the hard mask film by dry etching.

When a reflective photomask is held on a mask stage of an exposure apparatus, usually, the reflective photomask is secured by an electrostatic chuck. Therefore, the reflective photomask blank and the reflective photomask of the invention may include a conducting film (backside film) on the back surface of the substrate (the surface opposite to the front surface on which the multilayer reflection film or others are formed) for securing the reflective photomask by an electrostatic chuck. Further, the reflective photomask blank of the invention may further include a resist film formed on the hard mask film directly or via another film.

From the reflective photomask blank of the invention, for example, a reflective photomask including a substrate, a multilayer reflection film that is formed on the substrate, a protection film that is formed on the multilayer reflection film, and a pattern (circuit pattern or photomask pattern) of a light absorbing film that is formed on the protection film can be obtained.

The structures of the reflective photomask blank and the reflective photomask of the invention are described below with reference to the drawings. In the descriptions for the drawings, identical components may be given the same reference symbols and their duplicate descriptions may be omitted. In addition, the drawings may be enlarged for convenience, and the dimensional ratio of each component may not be the same as the actual ratio.

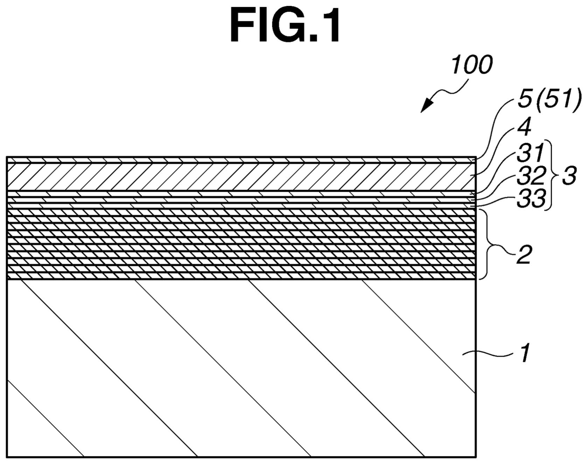

FIG. 1 is a cross-sectional view illustrating an example of a first embodiment of a reflective photomask blank of the invention. This reflective photomask blank 100 includes a substrate 1, a multilayer reflection film 2 that is formed on the substrate 1 and in contact with the substrate 1, a protection film 3 that is formed on the multilayer reflection film 2 and in contact with the multilayer reflection film 2, a light absorbing film 4 that is formed on the protection film 3 and in contact with the protection film 3, and a hard mask film 5 that is formed on the light absorbing film 4 and in contact with the light absorbing film 4. In this case, the protection film 3 is constituted of three layers consisting of an A layer 31 that is in contact with the light absorbing film 4, a C layer 33 that is in contact with the multilayer reflection film 2, and a B layer 32 that is in contact with the A layer 31 and the C layer 33. Further, the hard mask film is constituted of a first layer 51 only.

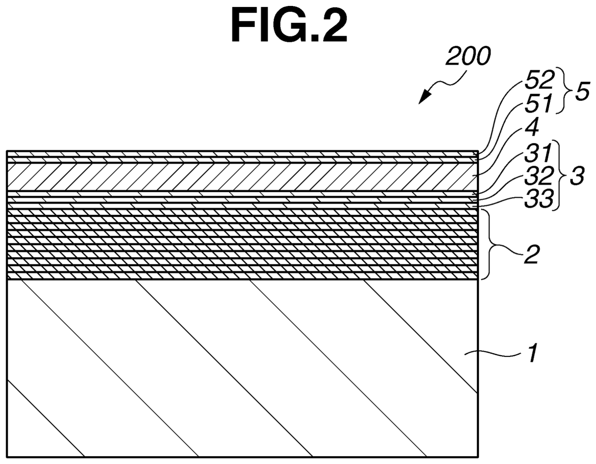

FIG. 2 is a cross-sectional view illustrating an example of a second embodiment of a reflective photomask blank of the invention. This reflective photomask blank 200 includes a substrate 1, a multilayer reflection film 2 that is formed on the substrate 1 and in contact with the substrate 1, a protection film 3 that is formed on the multilayer reflection film 2 and in contact with the multilayer reflection film 2, a light absorbing film 4 that is formed on the protection film 3 and in contact with the protection film 3, and a hard mask film 5 that is formed on the light absorbing film 4 and in contact with the light absorbing film 4. In this case, the protection film 3 is constituted of three layers consisting of an A layer 31 that is in contact with the light absorbing film 4, a C layer 33 that is in contact with the multilayer reflection film 2, and a B layer 32 that is in contact with the A layer 31 and the C layer 33. Further, the hard mask film is constituted of a first layer 51 that is formed in contact with the light absorbing film 4, and a second layer 52 that is formed in contact with the first layer 51.

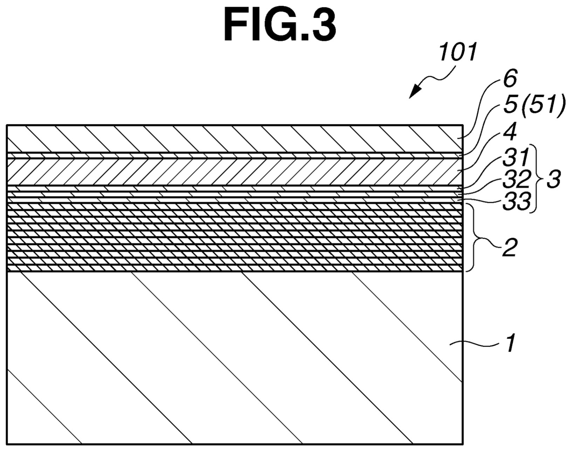

FIG. 3 is a cross-sectional view illustrating an example of a third embodiment of a reflective photomask blank of the invention. In this reflective photomask blank 101, a resist film 6 is formed in contact with the first layer 51 of the hard mask film 5 of the reflective photomask blain 100 in the first embodiment.

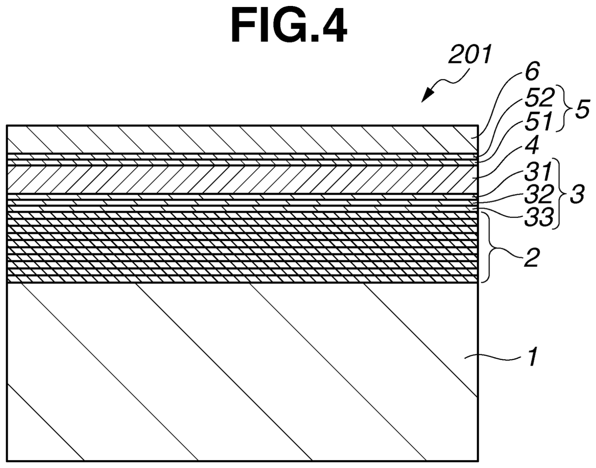

FIG. 4 is a cross-sectional view illustrating an example of a fourth embodiment of a reflective photomask blank of the invention. In this reflective photomask blank 201, a resist film 6 is formed in contact with the second layer 52 of the hard mask film 5 of the reflective photomask blain 200 in the second embodiment.

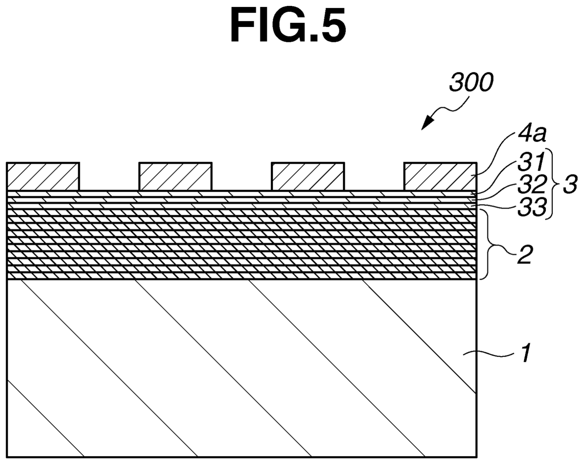

FIG. 5 is a cross-sectional view illustrating an example of a reflective photomask of the invention. This reflective photomask 300 includes, a substrate 1, a multilayer reflection film 2 that is formed on the substrate 1 and in contact with the substrate 1, a protection film 3 that is formed on the multilayer reflection film 2 and in contact with the multilayer reflection film 2, and a pattern of a light absorbing film 4a that is formed on the protection film 3 and in contact with the protection film 3. In this case, the protection film 3 is constituted of three layers consisting of an A layer 31 that is in contact with the pattern of the light absorbing film 4a, a C layer 33 that is in contact with the multilayer reflection film 2, and a B layer 32 that is in contact with the A layer 31 and the C layer 33.

A material or dimensions of the substrate are not particularly limited, and the substrate for the reflective photomask blank and the reflective photomask may or may not be transparent at the wavelength of exposure light. As the substrate, a glass substrate such as a quartz substrate may be used. A suitable substrate is, for example, a substrate called a 6025 substrate having dimensions of 6 inches square and 0.25 inches thick, which is defined in the SEMI standard. The 6025 substrate is generally represented a substrate having dimensions of 152 mm square and 6.35 mm thick in the SI unit system.

The multilayer reflection film is a film that reflects exposure light being light in extreme ultraviolet range. The multilayer reflection film is preferably formed in contact with the substrate. This light in extreme ultraviolet region is called EUV light, and the EUV light has a wavelength of 13 to 14 nm, and the EUV light generally has a wavelength of about 13.5 nm.

The multilayer reflection film is preferably composed of a material that is resistant to dry etching using a chlorine-based gas (chlorine-based dry etching), particularly, dry etching using a mixed gas of chlorine gas ($Cl_2$ gas) and oxygen gas ($O_2$ gas)) as the chlorine-based gas (dry etching using a chlorine-based gas containing oxygen (O)).

In particular, as materials forming the multilayer reflection film, for example, silicon (Si), molybdenum (Mo) and others are exemplified. As the multilayer reflection film, a laminated film (Si/Mo laminated film) in which about 20 to 60 layers of silicon (Si) layers and molybdenum (Mo) layers are alternately laminated is generally used.

The multilayer reflection film has a thickness of preferably not less than 200 nm, more preferably not less than 220 nm, and preferably not more than 340 nm, more preferably not more than 280 nm. The silicon (Si) layer has a thickness of preferably not less than 2 nm, more preferably not less than 3 nm, and preferably not more than 6 nm, more preferably not more than 5 nm. The molybdenum (Mo) layer has a thickness of preferably not less than 1 nm, more preferably not less than 2 nm, and preferably not more than 5 nm, more preferably not more than 4 nm.

The protection film is a film to protect the multilayer reflection film. The protection film is preferably formed in contact with the multilayer reflection film. The protection film is provided to protect the multilayer reflection film, for example, during cleaning in processing into a reflective photomask, during cleaning of the reflective photomask, or during correction of a pattern of a light absorbing film. Further, the protection film preferably has a function of protecting the multilayer reflection film when the light absorbing film is patterned by etching, or a function of preventing oxidation of the multilayer reflection film.

From the viewpoint of suppressing a blister defect, it is effective for the protection film to have a structure and a composition such that a part of the hydrogen plasma containing hydrogen ions or hydrogen radicals is released outside the protection film before the hydrogen plasma reaches the multilayer reflection film, and bubbles formed from hydrogen gas do not accumulate even if a part of the hydrogen plasma reaches the multilayer reflection film. Therefore, the protection film is preferably constituted of multiple layers including one A layer, one or two or more B layers, and one or two or more C layers. The A layer of the protection film is a layer that is in contact with the light absorbing film or the pattern of the light absorbing film. One of the C layer(s) is a film that is in contact with the multilayer reflection film. The B layer of the protection film is provided between the A layer, and the C layer that is in contact with the multilayer reflection film. The A layer is preferably in contact with the B layer. The B layer may be in contact with any layer selected from the group consisting of the A layer, the B layer and the C layer. The B layer is preferably in contact with the A layer and the C layer, or is preferably sandwiched between two C layers. The C layer may be in contact with any layer selected from the group consisting of the B layer and the C layer. The C layer is preferably in contact with the B layer, or is preferably sandwiched between two B layers. Particularly, the C layer that is in contact with the multilayer reflection film is preferably in contact with the B layer.

The protection film (each layer constituting the protection film), at least the A layer of the protection film, preferably the A layer and the B layer of the protection film) is preferably composed of a material that is resistant to dry etching using a chlorine-based gas (chlorine-based dry etching), particularly, dry etching using a mixed gas of chlorine gas ($Cl_2$ gas) and oxygen gas ($O_2$ gas)) as the chlorine-based gas (dry etching using a chlorine-based gas containing oxygen (O)). Further, the material forming the protection film (each layer constituting the protection film), at least the A layer of the protection film, preferably the A layer and the B layer of the protection film) is preferably a material that is resistant to a cleaning solution containing sulfuric acid or a cleaning solution containing an alkaline.

The protection film (each layer constituting the protection film), at least the A layer of the protection film, preferably the A layer and the B layer of the protection film) is preferably composed of a material that is more difficult to be etched by dry etching using a fluorine-based gas activated by an electron beam, compared to a light absorbing film. The protection film (each layer constituting the protection film), at least the A layer of the protection film, preferably the A layer and the B layer of the protection film) is preferably composed of a material that is more difficult to be etched by dry etching using a plasma formed by a fluorine-based gas, compared to a light absorbing film.

Since the A layer of the protection film is exposed in manufacturing the reflective photomask or in cleaning the reflective photomask, the A layer is necessary to be composed of a material having resistance to dry etching and resistance to a cleaning solution. The A layer is preferably composed of a material that can allow substantially all hydrogen plasma that has entered into the A layer to penetrate and to reach the B layer.

In particular, as a material forming the A layer, for example, a material containing rhodium (Rh) is exemplified. The material forming the A layer may be simple rhodium (Rh) or a rhodium (Rh) compound containing rhodium (Rh) and another metal, for example, ruthenium (Ru). The material forming the A layer may be a rhodium (Rh) compound containing oxygen (O), nitrogen (N), carbon (C), or others, however, is preferably simple rhodium (Rh) or a rhodium (Rh) compound consisting of rhodium (Rh) and the other metal, for example, ruthenium (Ru). As the rhodium (Rh) compound for the material forming the A layer, rhodium ruthenium (RhRu) and rhodium niobium ruthenium (RhNbRu) are exemplified. The A layer has a rhodium (Rh) content of preferably not less than 40 at%, more preferably not less than 50 at%. In the case that the A layer is a rhodium (Rh) compound, the A layer has a rhodium (Rh) content of less than 100 at%, preferably not more than 95 at%, more preferably not more than 90 at%.

The B layer is preferably composed of a material that can allow a part of the hydrogen plasma that has penetrated the A layer and entered into the B layer to penetrate, and to reach the layer at the substrate-side (another B layer or C layer), and can allow the remainder of the hydrogen plasma to put back to the layer at the side remote from the substrate (A layer, another B layer or C layer). If the B layer completely blocks the hydrogen plasma, hydrogen gas forms bubbles, and the bubbles accumulate at the interface between the B layer and the layer at the side remote from the substrate (A layer, another B layer or C layer), resulting in a blister defect. Therefore, it is preferable that the B layer is not composed of a material that completely blocks hydrogen plasma. When hydrogen plasma that does not penetrate the B layer is only a part, the hydrogen plasma does not accumulate at an amount enough to form hydrogen gas bubbles, the hydrogen plasma that has not penetrated the layer B returns to the layer remote from the substrate, and the returned hydrogen plasma is released to the outside of the protection film through the layer remote from the substrate. Thus, the B layer can be referred to have a function of adjusting the amount of hydrogen plasma that reaches the layer at the substrate-side.

In particular, as a material forming the B layer, for example, a material containing niobium (Nb) is exemplified. The material forming the B layer may be simple niobium (Nb) or a niobium (Nb) compound containing niobium (Nb) and another metal, for example, ruthenium (Ru) or molybdenum (Mo), however, is preferably free of rhodium (Rh). The material forming the B layer may be a niobium (Nb) compound containing oxygen (O), nitrogen (N), carbon (C), or others. As the niobium (Nb) compound for the material forming the B layer, niobium ruthenium (NbRu), niobium molybdenum (NbMo) and niobium oxide (NbO) are exemplified. The B layer has a niobium (Nb) content of preferably not less than 10 at%, more preferably not less than 15 at%. In the case that the B layer is a niobium (Nb) compound, the B layer has a niobium (Nb) content of less than 100 at%, preferably not more than 95 at%, more preferably not more than 90 at%.

The C layer is preferably composed of a material that can allow substantially all hydrogen plasma that has penetrated the A layer and the B layer and entered into the C layer to penetrate and to reach the layer or film at the substrate-side (B layer, another C layer or the multilayer reflection film). If the C layer completely blocks the hydrogen plasma, hydrogen gas forms bubbles, and the bubbles accumulate at the interface between the C layer and the layer at the side remote from the substrate (B layer or another C layer), resulting in a blister defect. Therefore, it is preferable that the layer C is not composed of a material that completely blocks hydrogen plasma. Since the B layer presents, the hydrogen plasma that has penetrated the A layer and the B layer and entered into the C layer is reduced compared to the hydrogen plasma that has been first entered into the A layer. The hydrogen plasma that penetrates the C layer reaches the layer or film at the substrate-side. In the case that the C layer is in contact with the multilayer reflection film, a part of the hydrogen plasma reacts with the surface layer of the multilayer reflection film, however, the remainder does not accumulate enough to form hydrogen gas bubbles. Further, in the case that the C layer is in contact with the B layer or the multilayer reflection film, the hydrogen plasma that has penetrated the layer C returns to the layer remote from the substrate, and the returned hydrogen plasma is released to the outside of the protection film through the layer remote from the substrate. Thus, the C layer can be referred to have a complementary function of suppressing a blister defect in the A layer and the B layer.

Further, the C layer is preferably composed of a material having a small extinction coefficient in the viewpoint of obtaining a protection film that is less likely to shield exposure light.

In particular, as a material forming the C layer, for example, a material containing molybdenum (Mo) is exemplified. Particularly, molybdenum (Mo) is effective in the viewpoint of obtaining a protection film that is less likely to shield exposure light. The material forming the C layer may be simple molybdenum (Mo) or a molybdenum (Mo) compound containing molybdenum (Mo) and another metal, for example, ruthenium (Ru), however, is preferably free of rhodium (Rh), and is preferably free of niobium (Nb). The material forming the C layer may contain oxygen (O), nitrogen (N), carbon (C), or others. As the molybdenum (Mo) compound, particularly, a molybdenum (Mo) compound containing molybdenum (Mo) and at least one selected from the group consisting of ruthenium (Ru), oxygen (O) and nitrogen (N) is preferable. As the molybdenum (Mo) compound for the material forming the C layer, molybdenum ruthenium (MoRu), molybdenum ruthenium oxide (MoRuO), molybdenum ruthenium nitride (MoRuN), and molybdenum ruthenium oxynitride (MoRuON) are exemplified. The C layer has a molybdenum (Mo) content of preferably not less than 30 at%, more preferably not less than 40 at%. In the case that the C layer is a molybdenum (Mo) compound, the C layer has a molybdenum (Mo) content of less than 100 at%, preferably not more than 95 at%, more preferably not more than 90 at%.

Normally, since the C layer of the protection film is not exposed in manufacturing the reflective photomask or in cleaning the reflective photomask, the C layer may not have resistance to dry etching and resistance to a cleaning solution.

The protection film may be multiple layers including a total of three or more layers of the A layer, the B layer(s) and the C layer(s), for example, multiple layers including a total of 3 to 10 layers of t the A layer, the B layer(s) and the C layer(s). The protection film is more preferably multiple layers consisting of the A layer, the B layer(s) and the C layer(s). As the protection film, for example, multiple layers consisting of three layers of, from the side remote from the substrate, the A layer, the B layer and the C layer, or multiple layers consisting of five layers of, from the side remote from the substrate, the A layer, the B layer, the C layer, the B layer and the C layer are exemplified. Two or more of the B layers, which have different compositions in adjacent layers, may be in contact with each other, and two or more of the C layers, which have different compositions in adjacent layers, may be in contact with each other. In particular, as such multi layers, multiple layers consisting of four layers of, from the side remote from the substrate, the A layer, the B layer, the B layer and the C layer, multiple layers consisting of four layers of, from the side remote from the substrate, the A layer, the B layer, the C layer and the C layer, and multiple layers consisting of five layers of, from the side remote from the substrate, the A layer, the B layer, the B layer, the C layer and the C layer. The protection film may have a gradient composition.

When the protection film is thin, a reflectance of exposure light from the multilayer reflection film of the reflective photomask is high, and in exposure using the reflective photomask, a larger amount of exposure light is irradiated onto a wafer, improving productivity in exposure using the reflective photomask. On the other hand, when the protection film is too thin, the protection film may be lost by dry etching or a cleaning solution in manufacturing a reflective photomask or using a reflective photomask, or the function as a protection film to protect the multilayer reflection film may be lost. Therefore, the protection film has a thickness (total thickness) of preferably not less than 1.5 nm, more preferably not less than 2 nm, and preferably not more than 6 nm, more preferably not more than 4 nm.

Further, each layer constituting the protection film has a thickness of preferably not less than 0.5 nm, more preferably not less than 0.8 nm, and preferably not more than 2 nm, more preferably not more than 1.5 nm for the same reason as the thickness (total thickness of the protection film. Furthermore, the A layer, the B layer(s) and the C layer(s) have a total thickness (in the case that a plurality of B layers and/or a plurality of C layers are included, all of the layers are included) of preferably not less than 40%, more preferably not less than 60%, even more preferably not less than 75%, further preferably 100% of the thickness (total thickness) of the protection film.

A blister defect is suppressed by the protection film having such a structure and composition, since a part of the hydrogen plasma is released outside the protection film before the hydrogen plasma reaches the multilayer reflection film, and even if a portion of the hydrogen plasma reaches the multilayer reflection film, the hydrogen gas does not form bubbles and accumulate.

A high reflectance in the combination of the multilayer reflection film and the protection film can provide a large amount of exposure light for utilizing photolithograph, therefore, the combination of the multilayer reflection film and the protection film has a reflectance of preferably not less than 63.5%, more preferably not less than 64%, even more preferably not less than 65.5%.

The light absorbing film is a film that absorbs exposure light being light in extreme ultraviolet range. The light absorbing film is usually formed in contact with the protection film. The light absorbing film may be constituted of a single layer or multiple layers (for example, 2 to 5 layers). Further, the light absorbing film may has a gradient composition.

The light absorbing film is preferably composed of a material that that can be etched by dry etching using a fluorine-based gas (for example, sulfur hexafluoride gas ($SF_6$), carbon tetrafluoride gas ($CF_4$) or others) (fluorine-based dry etching), in particular, for example, dry etching using a mixed gas of sulfur hexafluoride gas ($SF_6$) and helium gas (He). Further, the light absorbing film is preferably composed of a material that is resistant to dry etching using a chlorine-based gas (chlorine-based dry etching), particularly, dry etching using a mixed gas of chlorine gas ($Cl_2$ gas) and oxygen gas ($O_2$ gas)) as the chlorine-based gas (dry etching using a chlorine-based gas containing oxygen (O)).

The light absorbing film preferably contains ruthenium (Ru) and at least one metal selected from the group consisting of platinum (Pt), niobium (Nb), iridium (Ir), chromium (Cr), tantalum (Ta) and molybdenum (Mo). The light absorbing film may contain at least one element selected from the group consisting of oxygen (O), nitrogen (N), carbon (C) and boron (B).

The light absorbing film preferably contains ruthenium (Ru) and platinum (Pt). In the case that the light absorbing film is constituted of multiple layers, each layer constituting the multiple layers preferably contains both ruthenium (Ru) and platinum (Pt). As the material constituting the light absorbing film (a single layer or each layer constituting multiple layers), in particular, for example, ruthenium platinum (RuPt) is exemplified. Further, after a reflective photomask blank is processed to a reflective photomask, the light absorbing film is exposed to the air in environment for storage or environment for use in a wafer exposure apparatus. Therefore, the light absorbing film containing niobium (Nb) along with ruthenium (Ru) and platinum (Pt) is advantageous in the viewpoint of resistance to oxygen contained in the air. In particular, as the material containing niobium (Nb), for example, ruthenium platinum niobium (RuPtNb) is exemplified. The light absorbing film (a single layer or each layer constituting multiple layers) may contain at least one selected from the group consisting of oxygen (O), nitrogen (N), carbon (C) and boron (B), however, preferably consists of ruthenium (Ru) and platinum (Pt), or ruthenium (Ru), platinum (Pt) and niobium (Nb).

The light absorbing film (a single layer or each layer constituting multiple layers) has a ruthenium (Ru) content contained therein of preferably not less than 30 at%, more preferably not less than 40 at%, and preferably not more than 70 at%, more preferably not more than 60 at%. The light absorbing film (a single layer or each layer constituting multiple layers) has a platinum (Pt) content contained therein of preferably not less than 30 at%, more preferably not less than 40 at%, and preferably not more than 70 at%, more preferably not more than 60 at%. In addition, a total content of ruthenium (Ru) and platinum (Pt) of the light absorbing film is preferably not less than 96 at%, more preferably not less than 97 at%, and may be 100 at%. In the case that the light absorbing film contains niobium (Nb), the light absorbing film has a niobium (Nb) content of preferably not more than 4 at%, more preferably not more than 3 at%. In this case, the lower limit of the niobium (Nb) content is more than 0 at%, and the niobium (Nb) content is preferably not less than 1 at%, however, not particularly limited thereto.

In the invention, the light absorbing film may be a film not having a phase shift function (a film that does not substantially reflect exposure light) or a film having a phase shift function, i.e., a phase shift film, however, is preferably a film having a phase shift function. A light absorbing film having a phase shift function is a film that absorbs a part of exposure light and reflects the remaining part with changing (shifting) phase relative to phase of the exposure light reflected from the multilayer reflection film, thereby obtaining a phase shift function due to phase shift between the light reflected from the multilayer reflection film and the light reflected from the light absorbing film.

In the case of the light absorbing film is a light absorbing film not having a phase shift function, the reflective photomask blank and the reflective photomask of the invention can be referred to as a binary type reflective photomask blank and a binary type reflective photomask, respectively. On the other hand, in the case of the light absorbing film is a light absorbing film having a phase shift function, the reflective photomask blank and the reflective photomask of the invention can be referred to as a reflective photomask blank having a phase shift function (a reflective phase shift photomask blank) and a reflective photomask having a phase shift function (a reflective phase shift photomask), respectively. The light absorbing film having the phase shift function can improve wafer transfer characteristics (NILS).

When the light absorbing film has a high reflectance with respect to exposure light being light in extreme ultraviolet range, the light absorbing film having a phase shift function (a phase shift film) tends to have a large difference of optimal focus values depending on the sizes (pitches) of a line and space pattern on a wafer. When the light absorbing film has a large difference of optimal focus values depending on the sizes (pitches) of line and space pattern on a wafer, line and space patterns having different sizes (pitches) cannot be provided in one device circuit pattern, and design for a photomask significantly restricted.

When a single device circuit pattern has a mixture of line and space patterns that include lines and spaces having different sizes (pitches), in the viewpoint of obtaining a good device circuit pattern in each of the line and space patterns, the light absorbing film having a phase shift function (phase shift film) has a reflectance of preferably not less than 1%, more preferably not less than 2%, and preferably not more than 8%, more preferably not more than 6%, with respect to exposure light being light in extreme ultraviolet range. The light absorbing film having such a reflectance has a small difference in optimal focus values of line and space patterns having different sizes (pitches), and it is advantageous in providing line and space patterns having different sizes (pitches) in a single device circuit pattern.

The reflectance is a relative reflectance with respect to a portion where the light absorbing film is not formed. In particular, the reflectance is a ratio of the reflectance of the light reflected from the light absorbing film that is formed via the multilayer reflection film and the protection film on the substrate relative to the reflectance of the light reflected from the multilayer reflection film and the protection film that are formed on the substrate.

The light absorbing film having a phase shift function (phase shift film) has a phase shift of preferably not less than 190 degrees, more preferably not less than 200 degrees, and preferably not more than 240 degrees, more preferably not more than 230 degrees, with respect to exposure light being light in extreme ultraviolet range. The phase shift is a relative phase shift with respect to a portion where the light absorbing film is not formed. In particular, the phase shift is a difference between the phase of the light reflected from the multilayer reflection film and the protection film that are formed on the substrate, and the phase of the light reflected from the light absorbing film that is formed via the multilayer reflection film and the protection film on the substrate.

The light absorbing film has a thickness of preferably not less than 32 nm, more preferably not less than 34 nm, and preferably not more than 38 nm, more preferably not more than 37 nm, even more preferably not more than 36 nm, in the viewpoint of reducing influence of shadowing effect, particularly, in the viewpoint of ensuring a light absorbing function and a phase shift function in the case of a light absorbing film having a phase shift function.

In the case that the pattern of the light absorbing film does not have a desired shape, the pattern is subjected to correction. For correcting a reflective photomask, electron beam correction having high processing accuracy for a photomask pattern is mainly used. The correction for a light absorbing film composed of a material containing ruthenium (Ru) and platinum (Pt), a fluorine-based gas such as xenon fluoride ($XeF_2$) is used, and a minute area can be processed by dry etching using a fluorine-based gas activated by an electron beam to correct the pattern of the light absorbing film. The light absorbing film is preferably composed of a material that is etched by only the dry etching using a fluorine-based gas activated by an electron beam. Further, the light absorbing film preferably has a structure than can be etched by only the dry etching using a fluorine-based gas activated by an electron beam. As a film having the structure, a single-layer light absorbing film, or a multilayer (for example, 2 to 5 layers) light absorbing film that is constituted of layers with the same or similar etching characteristics.

Furthermore, in a manufacturing process of a reflective photomask, a cleaning process may be performed multiple times to remove foreign matter on the photomask. Therefore, the protection film has a thickness of preferably not less than 1.1 nm, more preferably note less than 1.2 nm, even more preferably not less than 2 nm, further preferably not less than 2.2 nm just after forming the pattern of the light absorbing film, and obtaining the reflective photomask from the reflective photomask blank.

The hard mask film is a film that functions as an etching mask in etching the light absorbing film. The hard mask film is usually formed in contact with the light absorbing film. The hard mask film may be constituted of a single layer film or a multilayer film (for example, two layers, three layers, four layers or five layers). Further, the hard mask film may also be a film having a gradient composition.

The hard mask film preferably includes a first layer that is in contact with the light absorbing film, and functions as an etching mask in patterning the light absorbing film by dry etching. The first layer of the hard mask film is preferably composed of a material that is resistant to dry etching using a fluorine-based gas (for example, sulfur hexafluoride gas ($SF_6$), carbon tetrafluoride gas ($CF_4$) or others) (fluorine-based dry etching), in particular, for example, dry etching using a mixed gas of sulfur hexafluoride gas ($SF_6$) and helium gas (He). Further, the first layer of the hard mask film is preferably composed of a material that can be etched by dry etching using a chlorine-based gas (chlorine-based dry etching), particularly, dry etching using a mixed gas of chlorine gas ($Cl_2$ gas) and oxygen gas ($O_2$ gas)) as the chlorine-based gas (dry etching using a chlorine-based gas containing oxygen (O)).

The first layer of the hard mask film is preferably composed of a material that contains either or both of chromium (Cr) and ruthenium (Ru). The first layer of the hard mask film is preferably composed of a material that is free of both silicon (Si) and tantalum (Ta). The material forming the first layer of the hard mask film may contain at least one selected from the group consisting of oxygen (O), nitrogen (N), carbon (C) and boron (B). As the material of the first layer of the hard mask film, in particular, chromium oxide (CrO), chromium nitride (CrN), chromium oxynitride (CrON), chromium carbide (CrC), chromium oxynitride carbide (CrONC), ruthenium oxide (RuO), ruthenium nitride (RuN), and ruthenium oxynitride (RuON) are exemplified.

If the first layer of the hard mask film is too thin, the function as an etching mask in etching the light absorbing film may be lost, and sensitivity of defect inspection of the first layer of the hard mask film may decrease. Therefore, the first layer of the hard mask film has a thickness of preferably not less than 2 nm, more preferably not less than 4 nm. Further, when the first layer of the hard mask film is removed by dry etching, usually, the protection film is also exposed to dry etching at the same time. If the first layer of the hard mask film is too thick, a large amount of the protection film is lost. Therefore, the first layer of the hard mask film has a thickness of preferably not more than 14 nm, more preferably not more than 10 nm.

Further, the hard mask film preferably includes a second layer that is in contact with the first layer of the hard mask film, and functions as an etching mask in patterning the first layer of the hard mask film by dry etching. The second layer of the hard mask film is preferably composed of a material that is resistant to dry etching using a chlorine-based gas (chlorine-based dry etching), particularly, dry etching using a mixed gas of chlorine gas ($Cl_2$ gas) and oxygen gas ($O_2$ gas)) as the chlorine-based gas (dry etching using a chlorine-based gas containing oxygen (O)). Further, the second layer of the hard mask film is preferably composed of a material that can be etched by dry etching using a fluorine-based gas (for example, sulfur hexafluoride gas ($SF_6$), carbon tetrafluoride gas ($CF_4$) or others) (fluorine-based dry etching), in particular, for example, dry etching using a mixed gas of sulfur hexafluoride gas ($SF_6$) and helium gas (He).

The second layer of the hard mask film is preferably composed of a material that contains either or both of silicon (Si) and tantalum (Ta). The second layer of the hard mask film is preferably composed of a material that is free of both chromium (Cr) and ruthenium (Ru). The material forming the second layer of the hard mask film may contain at least one selected from the group consisting of oxygen (O), nitrogen (N), carbon (C) and boron (B). As the material of the second layer of the hard mask film, in particular, silicon nitride (SiN), silicon oxynitride (SiON), tantalum oxide (TaO), tantalum nitride (TaN), and tantalum oxynitride (TaON) are exemplified.

If the second layer of the hard mask film is too thin, the function as an etching mask in etching the first layer of the hard mask film may be lost, and sensitivity of defect inspection of the second layer of the hard mask film may decrease. Therefore, the second layer of the hard mask film has a thickness of preferably not less than 2 nm, more preferably not less than 4 nm. Further, a resist film is usually used for etching the second layer of the hard mask film, and a thin resist film has an advantage in miniaturization of pattern formation. Therefore, the second layer of the hard mask film has a thickness of preferably not more than 14 nm, more preferably not more than 10 nm.

The conducting film is preferably formed in contact with the substrate. The conducting film preferably has a sheet resistance of not more than 100 $\Omega$/square, and the conducting film does not have any limitation in materials. As the material for the conducting film, for example, a material containing tantalum (Ta) or chromium (Cr) is exemplified. Further, the material containing tantalum (Ta) or chromium (Cr) may contain at least one selected from the group consisting of oxygen (O), nitrogen (N), carbon (C) and boron (B). The conducting film has a thickness enough to act for use in electrostatic chucking, and usually has a thickness of about 20 to 300 nm, however, not particularly limited thereto.

In the invention, an electron beam resist that is drawn with an electron beam or a photoresist that is drawn with light may be used for the resist film, and a chemically amplified resist is preferable. The chemically amplified resist may be a positive type or a negative type, and examples of the resists include a resist containing a base resin such as a hydroxystyrene-based resin or a (meth)acrylic acid-based resin, and an acid generator, and optionally containing a cross-linking agent, a quencher, a surfactant, or other components.

The resist film has a thickness of preferably not more than 100 nm, more preferably not more than 80 nm. With respect to a resist pattern for forming a fine assist pattern, in the developing step for forming the resist pattern, in the viewpoint of forming the resist pattern that is hard to be collapsed by impact of a development solution or impact of pure water during rinsing process, the resist film has a thickness of even more preferably not more than 60 nm. The resist film has a thickness as a lower limit that functions as an etching mask in etching, i.e., a thickness that can maintain a resist pattern on the entire surface of the film to be etched after etching, and can be formed with a stable thickness. The lower limit is preferably not less than 30 nm, more preferably not less than 40 nm.

In the invention, the multilayer reflection film, the protection film, the light absorbing film, the hard mask film and the conducting film are preferably formed by a sputtering method since the sputtering method has good controllability and is easy to form a film having predetermined characteristics, however, not particularly limited thereto. As a system of the sputtering, a DC sputtering system or an RF sputtering system can be applied, however, not particularly limited thereto.

When a laminated film of molybdenum (Mo) layers and silicon (Si) layers is formed as the multilayer reflection film, a molybdenum (Mo) target and a silicon (Si) target may be used as sputtering targets.

When the protection film (each layer constituting the protection film) is composed of a material containing rhodium (Rh), a rhodium (Rh) target may be used as a sputtering target. When the protection film (each layer constituting the protection film) is composed of a material containing niobium (Nb), a niobium (Nb) target may be used as a sputtering target. When the protection film (each layer constituting the protection film) is composed of a material containing molybdenum (Mo), a molybdenum (Mo) target may be used as a sputtering target. When the protection film (each layer constituting the protection film) is composed of a material containing ruthenium (Ru), a ruthenium (Ru) target may be used as a sputtering target. Further, a target containing another element constituting the protection film (each layer constituting the protection film) may be used, if needed.

When the light absorbing film is composed of a material containing ruthenium (Ru), a ruthenium (Ru) target may be used as a sputtering target. When the light absorbing film is composed of a material containing platinum (Pt), a platinum (Pt) target may be used as a sputtering target. When the light absorbing film is composed of a material containing niobium (Nb), a niobium (Nb) target may be used as a sputtering target. A target containing another element constituting the light absorbing film may be used, if needed.

When a layer composed of a material containing chromium (Cr) is formed as the first layer of the hard mask film, a chromium (Cr) target may be used as a sputtering target. Further, when a layer composed of a material containing ruthenium (Ru) is formed as the first layer of the hard mask film, a ruthenium (Ru) target may be used as a sputtering target.

On the other hand, when a layer composed of a material containing silicon (Si) is formed as the second layer of the hard mask film, a silicon (Si) target may be used as a sputtering target. Further, when a layer composed of a material containing tantalum (Ta) is formed as the second layer of the hard mask film, a tantalum (Ta) target may be used as a sputtering target.

When a conducting film is composed of a material containing tantalum (Ta) or chromium (Cr), a tantalum (Ta) target or a chromium (Cr) target may be used as a sputtering target.

In the case that the film or the layer constituting the film contains boron (B), a target containing the metal constituting the above-mentioned target added with boron (B) (a metal boride target or others) may be used.

A power to be supplied to the sputtering target may be appropriately set depending on dimensions of the sputtering target, cooling efficiency, controllability of film formation or others. The power is normally 50 to 3000 $W/cm^2$ as a power per area of the sputtering surface of the sputtering target. Further, as a sputtering gas, a rare gas such as helium gas (He gas), neon gas (Ne gas), argon gas (Ar gas) or others may be used. When the film or the layer constituting the film that contains only the element constituting the target is formed, only the rare gas may be used as the sputtering gas.

When the film or the layer constituting the film is composed of a material containing oxygen (O), nitrogen (N) or carbon (C), the sputtering is preferably reactive sputtering. A rare gas such as helium gas (He gas), neon gas (Ne gas), argon gas (Ar gas) and others, and a reactive gas are used as sputtering gases for the reactive sputtering.

When the film or the layer constituting the film is composed of a material containing oxygen (O), oxygen gas ($O_2$ gas) may be used as the reactive gas. When the film or the layer constituting the film is composed of a material containing nitrogen (N), nitrogen gas ($N_2$ gas) may be used as the reactive gas. When the film or the layer constituting the film is composed of a material containing oxygen (O) and nitrogen (N), the reactive gas may be appropriately selected and used from oxygen gas ($O_2$ gas), nitrogen gas ($N_2$ gas), and a nitrogen oxide gas such as nitrogen monoxide gas (NO gas), nitrogen dioxide gas ($NO_2$ gas) and nitrous oxide gas ($N_2O$ gas). When the film or the layer constituting the film is composed of a material containing carbon, a gas containing carbon such as methane gas ($CH_4$), carbon monoxide gas (CO gas) and carbon dioxide gas ($CO_2$ gas) may be used as the reactive gas. When the film or the layer constituting the film is composed of a material containing nitrogen (N), oxygen (O) and carbon (C), for example, nitrogen gas ($N_2$ gas), oxygen gas ($O_2$ gas), and carbon dioxide gas ($CO_2$) may be used simultaneously.

A pressure in forming the film or the layer constituting the film may be appropriately set in consideration of film stress, chemical resistance, cleaning resistance or others. Particularly, the chemical resistance is improved by setting the pressure at preferably not less than 0.01 Pa, more preferably not less than 0.03 Pa, and preferably not more than 1 Pa, more preferably not more than 0.3 Pa. Further, a flow rate of each gas may be appropriately set so as to obtain a desired composition, and may be set to normally 0.1 to 100 sccm.

In a manufacturing process of the reflective photomask blank, the substrate or the substrate and the film formed on the substrate may be heat-treated before forming the resist film. As a method of the heat treatment, an infrared heating, a resistance heating or others can be applied, and conditions for the treatment are not particularly limited. The heat treatment may be performed, for example, under an atmosphere of a gas containing oxygen (O). The gas containing oxygen(O) has a concentration of, for example, 1 to 100 vol% in the case of oxygen gas ($O_2$ gas), however, not particularly limited thereto. The heat treatment is performed at a temperature of preferably not less than 200 °C, more preferably not less than 400 °C.

In a manufacturing process of the reflective photomask blank, before forming the resist film, the films that are formed on the substrate may be subjected to ozone treatment, or plasma treatment, and conditions for the treatment are not particularly limited. Each treatment may be performed to increase oxygen (O) concentration in the surface portion of the film. In this case, conditions for the treatment may be appropriately adjusted so as to obtain a predetermined oxygen (O) concentration. In addition, in the case that the film is formed by sputtering, the oxygen (O) concentration in the surface portion of the film can be increased also by adjusting a ratio of a rare gas, and a gas containing oxygen (oxidizing gas) such as oxygen gas ($O_2$ gas), carbon monoxide gas (CO gas), and carbon dioxide gas ($CO_2$ gas) in the sputtering gas.

In a manufacturing process of the reflective photomask blank, before forming the resist film, a cleaning treatment may be performed to remove defects which present on the surface of the substrate or the film formed on the substrate. The cleaning can be performed with using either or both of ultrapure water and a functional water, which is ultrapure water containing ozone gas ($O_3$ gas), hydrogen gas ($H_2$ gas), or others. Further, the cleaning may be performed by ultrapure water containing a surfactant, followed by cleaning with either or both of ultrapure water and the functional water. The cleaning may be performed while irradiating with ultrasonic wave, if need, and may be further performed with combining UV light irradiation.

A method of forming the resist film (applying the resist) is not particularly limited, and a known method such as spin coating may be applied.

From a reflective photomask blank of the invention, a reflective photomask including a substrate, a multilayer reflection film, a protection film and a pattern of a light absorbing film can be manufactured.

In manufacturing the reflective photomask, when no resist film is formed in the reflective photomask blank, a resist film is formed in contact with the film remotest from the substrate of the reflective photomask blank, for example, the hard mask film, at the side remote from the substrate. After that, the reflective photomask can be manufactured by patterning the film in contact with the resist film with using a resist pattern obtained by patterning the resist film, as an etching mask, and appropriately selecting an etching according to etching characteristics of the film, and further, by patterning the film at the substrate-side with appropriately selecting an etching according to etching characteristics of the film in sequence. In manufacturing the reflective photomask, the resist pattern can be removed by a sulfuric acid-hydrogen peroxide mixture (SPM).

In particular, as a method for manufacturing a reflective photomask from the reflective photomask blank of the invention, the following method is exemplified.

In the case that a reflective photomask is manufactured from a reflective photomask brank including the first layer of the hard mask film (a reflective photomask blank of the first embodiment), the reflective photomask can be manufactured by a method (a manufacturing method of a first embodiment) including the steps of:

(A1) forming a resist film in contact with the first layer of the hard mask film at the side remote from the substrate,
(B) patterning the resist film to form a resist pattern,
(C1) patterning the first layer of the hard mask film to form a pattern of the first layer of the hard mask film by dry etching using a chlorine-based gas and the resist pattern as an etching mask,
(D) removing the resist pattern,
(F1) patterning the light absorbing film to form a pattern of the light absorbing film by dry etching using a fluorine-based gas and the pattern of the first layer of the hard mask film as an etching mask, and
(G1) removing the pattern of the first layer of the hard mask film by dry etching using a chlorine-based gas. When the reflective photomask blank including a resist film (a reflective photomask blank of the third embodiment) is used, the step (A1) may be omitted.

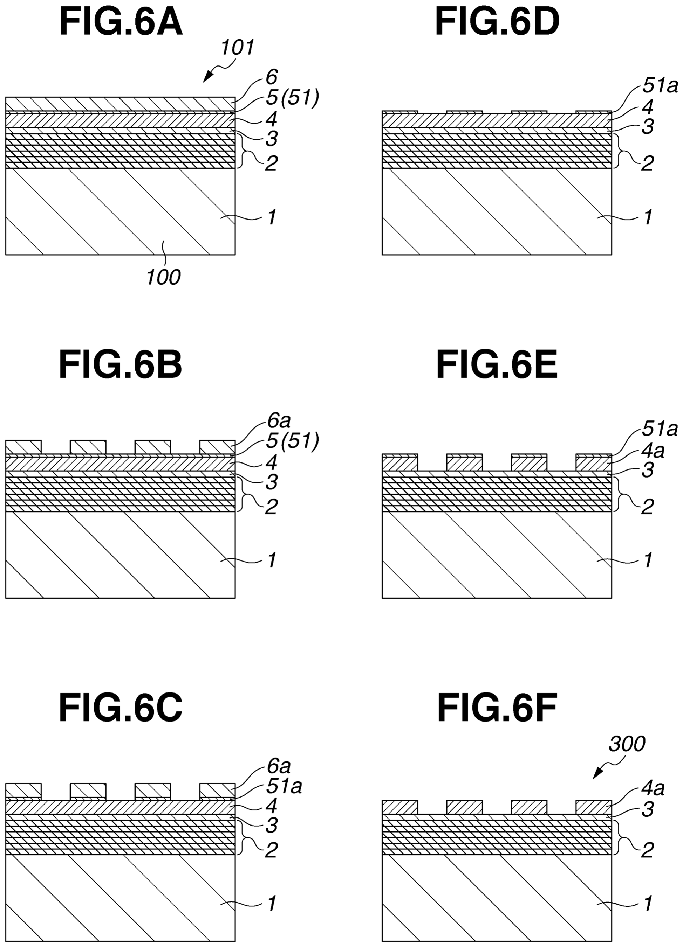

FIGS. 6A to 6F are cross-sectional views illustrating an example of steps for manufacturing a reflective photomask from a reflective photomask blank of the first or third embodiment of the of the invention. In the manufacturing method of the first embodiment, the reflective photomask can be manufactured by preforming the following steps in sequence. In FIGS. 6A to 6F, the protection film 3 is constituted of multiple layers including the A, the B layer(s) and the C layer(s), for example, as shown in FIG. 1 to FIG. 5, however, not shown in the drawings.

First, (A1) a resist film is formed in contact with the first layer of the hard mask film at the side remote from the substrate, if needed (FIG. 6A). When the reflective photomask blank 100 of the first embodiment is used, a resist film 6 is formed thereon, and when the reflective photomask blank 101 of the third embodiment including the resist film 6 is used, the reflective photomask blank 101 can be used without performing this step.

Next, (B) the resist film 6 is patterned to form a resist pattern 6a (FIG. 6B).

Next, (C 1) the first layer 51 of the hard mask film is patterned to form a pattern a of the first layer 51a of the hard mask film by dry etching using a chlorine-based gas and the resist pattern 6a as an etching mask (FIG. 6C).

Next, (D) the resist pattern 6a is removed (FIG. 6D). The step (D) may be performed after the step (C1) or the step (F1).

Next, (F1) the light absorbing film 4 is patterned to form a pattern of the light absorbing film 4a by dry etching using a fluorine-based gas and the pattern of the first layer 51a of the hard mask film as an etching mask (FIG. 6E).

Next, (G1) the pattern of the first layer 51a of the hard mask is removed by dry etching using a chlorine-based gas (FIG. 6F), thereby obtaining a reflective photomask 300.

The dry etching using a fluorine-based gas in step (F1) and the subsequent dry etching using a chlorine-based gas in step (G1) are preferably conducted so that the protection film remains after the pattern of the first layer is removed (after the etching of the pattern of the first layer is completed), particularly, are preferably conducted so that the A layer of the protection film remains after the pattern of the first layer is removed.

In the case that a reflective photomask is manufactured from a reflective photomask brank including the first and second layers of the hard mask film (a reflective photomask blank of the second embodiment), the reflective photomask can be manufactured by a method (a manufacturing method of a second embodiment) including the steps of:

(A2) forming a resist film in contact with the second layer of the hard mask film at the side remote from the substrate,
(B) patterning the resist film to form a resist pattern,
(C2) patterning the second layer of the hard mask film to form a pattern of the second layer of the hard mask film by dry etching using a fluorine-based gas and the resist pattern as an etching mask,
(D) removing the resist pattern,
(E2) patterning the first layer of the hard mask film to form a pattern of the first layer of the hard mask film by dry etching using a chlorine-based gas and the pattern of the second layer of the hard mask film as an etching mask,
(F2) patterning the light absorbing film to form a pattern of the light absorbing film by dry etching using a fluorine-based gas and the pattern of the first layer of the hard mask film as an etching mask with removing the pattern of the second layer of the hard mask film, and
(G2) removing the pattern of the first layer of the hard mask film by dry etching using a chlorine-based gas. When the reflective photomask blank including a resist film (a refractive photomask blank of the fourth embodiment) is used, the step (A2) may be omitted.

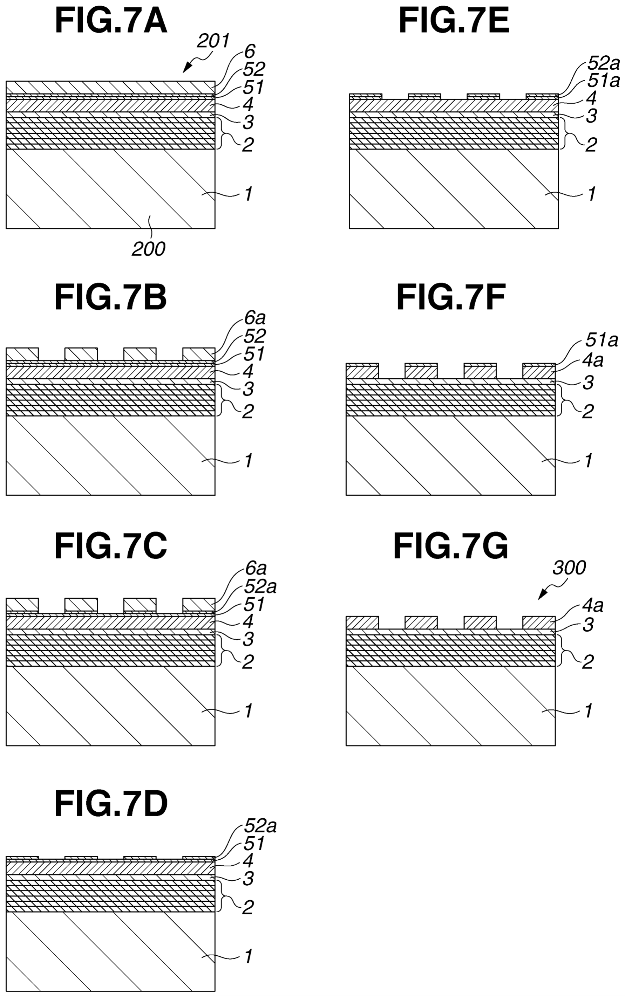

FIGS. 7A to 7G are cross-sectional views illustrating an example of steps for manufacturing a reflective photomask from a reflective photomask blank of the second or fourth embodiment of the invention. In the manufacturing method of the second embodiment, the reflective photomask can be manufactured by preforming the following steps in sequence. In FIGS. 7A to 7G, the protection film 3 is constituted of multiple layers including the A, the B layer(s) and the C layer(s), for example, as shown in FIG. 1 to FIG. 5, however, not shown in the drawings.

First, (A2) a resist film is formed in contact with the second layer of the hard mask film at the side remote from the substrate, if needed (FIG. 7A). When the reflective photomask blank 200 of the second embodiment is used, a resist film 6 is formed thereon, and when the reflective photomask blank 201 of the fourth embodiment including the resist film 6 is used, the reflective photomask blank 201 can be used without performing this step.

Next, (B) the resist film 6 is patterned to form a resist pattern 6a (FIG. 7B).

Next, (C2) the second layer 52 of the hard mask film is patterned to form a pattern a of the second layer 52a of the hard mask film by dry etching using a fluorine-based gas and the resist pattern 6a as an etching mask (FIG. 7C).

Next, (D) the resist pattern 6a is removed (FIG. 7D). The step (D) may be performed after the step (C2) or the step (E2).

Next, (E2) the first layer 51 of the hard mask film is patterned to form a pattern a of the first layer 51a of the hard mask film by dry etching using a chlorine-based gas and the pattern a of the second layer 52a of the hard mask film as an etching mask (FIG. 7E).

Next, (F2) the light absorbing film 4 is patterned to form a pattern of the light absorbing film 4a by dry etching using a fluorine-based gas and the pattern of the first layer 51a of the hard mask film as an etching mask with removing the pattern of the second layer 52a of the hard mask film (FIG. 7F).

Next, (G2) the pattern of the first layer 51a of the hard mask is removed by dry etching using a chlorine-based gas (FIG. 7G), thereby obtaining a reflective photomask 300.

The dry etching using a fluorine-based gas in step (F2) and the subsequent dry etching using a chlorine-based gas in step (G2) are preferably conducted so that the protection film remains after the pattern of the first layer is removed (after the etching of the pattern of the first layer is completed), particularly, are preferably conducted so that the A layer of the protection film remains after the pattern of the first layer is removed..

From the reflective mask blank of the invention, even when a resist film used for manufacturing a reflective mask is thin, for example, even when the resist film has a thickness of about 60 nm, a good assist pattern having a line width of about 25 nm, particularly about 20 nm, can be formed.

EXAMPLES

Examples of the invention are given below by way of illustration and not by way of limitation.

Example 1A

A reflective photomask blank was manufactured by laminating a multilayer reflection film, a protection film (an A layer, a B layer and a C layer), a light absorbing film and a hard mask film (a first layer and a second layer) in the order on a quartz substrate having dimensions of 152 mm square and about 6 mm thick.

First, the multilayer reflection film that was a laminated film (thickness: 280 nm) in which molybdenum (Mo) layers and silicon (Si) layers were alternately laminated and had a reflectance of 65% with respect to light having a wavelength of 13.5 nm was formed on the quartz substrate with using a molybdenum (Mo) target and a silicon (Si) target as targets, and argon gas (Ar gas) as a sputtering gas, by performing sputtering of the molybdenum (Mo) target and sputtering of the silicon (Si) target, alternately, with adjusting applied powers to the targets and a flow rate of the sputtering gas. The molybdenum (Mo) layers and the silicon (Si) layers were laminated for 40 cycles (40 molybdenum (Mo) layers and 40 silicon (Si) layers, respectively).

Next, a layer composed of molybdenum (Mo) as the C layer of the protection film was formed on the multilayer reflection film with using a molybdenum (Mo) target as a target, and argon gas (Ar gas) as a sputtering gas, by performing sputtering of the molybdenum (Mo) target, with adjusting an applied power to the target and a flow rate of the sputtering gas.

Next, a layer composed of niobium ruthenium (NbRu) as the B layer of the protection film was formed on the C layer of the protection film with using a niobium (Nb) target and a ruthenium (Ru) target, as targets, and argon gas (Ar gas) as a sputtering gas, by performing sputtering of the niobium (Nb) target and the ruthenium (Ru) target, with adjusting applied powers to the targets and a flow rate of the sputtering gas.

Next, a layer composed of rhodium (Rh) as the A layer of the protection film was formed on the B layer of the protection film with using a rhodium (Rh) target as a target, and argon gas (Ar gas) as a sputtering gas, by performing sputtering of the rhodium (Rh) target, with adjusting an applied power to the target and a flow rate of the sputtering gas. As a result, the protection film consisting of three layers of, from the side remote from the substrate, the A layer, the B layer and the C layer was formed.

In connection with the protection film, the compositions and the thickness of each layer (the A layer, the B layer and the C layer), and the total thickness of the protection film, and the reflectance, which was a reflectance of the combination of the multilayer reflection film and protection film with respect to light having a wavelength of 13.5 nm, are shown in Table 1A. The compositions were analyzed by an X-ray photoelectron spectrometer, and the same method was applied to the analysis of composition in followings. The thickness was measured by an X-ray diffraction device, and the same method was applied to the measurement of thickness in followings. The reflectance was measured by a reflectometer with respect to light having an incident angle of 6 degrees, and the same method was applied to the measurement of reflectance in followings.

Next, the light absorbing film composed of ruthenium platinum (RuPt) was formed on the protection film with using a ruthenium (Ru) target and a platinum (Pt) target as targets, and argon gas (Ar gas) as a sputtering gas, by sputtering with adjusting applied powers to the targets and a flow rate of the sputtering gas.

The light absorbing film had a composition having a ruthenium (Ru) content of 52 at% and a platinum (Pt) content of 48 at%, a thickness of 36 nm, a reflectance (relative reflectance to the multilayer reflection film and the protection film) of 4.9% with respect to light having a wavelength of 13.5 nm, and a phase shift (relative phase shift to the multilayer reflection film and the protection film) of 211 degrees with respect to light having a wavelength of 13.5 nm. The refractive index and extinction coefficient were measured by a refractive index/extinction coefficient measuring instrument, and the phase shift was calculated from these measured values, and the same method was applied to the calculation of phase shift in followings.

Next, the first layer of the hard mask film composed of chromium oxynitride carbide (CrONC) was formed on the light absorbing film with using a chromium (Cr) target as a target, and argon gas (Ar gas), oxygen gas ($O_2$ gas), nitrogen gas ($N_2$ gas) and carbon dioxide gas ($CO_2$ gas), as sputtering gases, by sputtering with adjusting an applied power to the target and flow rates of the sputtering gases.

Next, the second layer of the hard mask film composed of silicon oxynitride (SiON) was formed on the first layer of the hard mask film with using a silicon (Si) target as a target, and argon gas (Ar gas), oxygen gas ($O_2$ gas) and nitrogen gas ($N_2$ gas), as sputtering gases, by sputtering with adjusting an applied power to the target and flow rates of the sputtering gases. As a result, the reflective photomask blank was obtained. In connection with the first layer and the second layer of

the hard mask film, the compositions and the thicknesses are shown in Table 2.

Examples 2A to 17A and Comparative Examples 1A to 9A

The multilayer reflection film was formed in the same manner as in Example 1A. The protection film was formed in the same manner as in Example 1A, under the same or different conditions in the applied powers to the targets, the flow rates of the sputtering gases, and the sputtering time. The light absorbing film was formed in the same manner as in Example 1A. The first layer of the hard mask film alone (in Example 17A), or both of the first and second layers of the hard mask film (in Examples 2A to 16A and Comparative Examples 1A to 9A) were formed in the same manner as in Example 1A, under the same or different conditions in the applied power to the target, the flow rates of the sputtering gases, and the sputtering time. As a result, the reflective photomask blanks were obtained.

In Example 2A, a layer composed of molybdenum ruthenium (MoRu) as the C layer of the protection film was formed with using a molybdenum (Mo) target and a ruthenium (Ru) target, as targets, and argon gas (Ar gas) as a sputtering gas, by performing sputtering of the molybdenum (Mo) target and the ruthenium (Ru) target, with adjusting applied powers to the targets and a flow rate of the sputtering gas. Other than the C layer of the protection film, the same manner as in Example 1A was applied.

In Example 3A, a layer composed of molybdenum ruthenium oxide (MoRuO) as the C layer of the protection film was formed with using a molybdenum (Mo) target and a ruthenium (Ru) target, as targets, and argon gas (Ar gas) and oxygen gas ($O_2$ gas), as sputtering gases, by performing sputtering of the molybdenum (Mo) target and the ruthenium (Ru) target, with adjusting applied powers to the targets and flow rates of the sputtering gases. Other than the C layer of the protection film, the same manner as in Example 1A was applied.

In Example 4A, a layer composed of molybdenum ruthenium nitride (MoRuN) as the C layer of the protection film was formed with using a molybdenum (Mo) target and a ruthenium (Ru) target, as targets, and argon gas (Ar gas) and nitrogen gas ($N_2$ gas), as sputtering gases, by performing sputtering of the molybdenum (Mo) target and the ruthenium (Ru) target, with adjusting applied powers to the targets and flow rates of the sputtering gases. Other than the C layer of the protection film, the same manner as in Example 1A was applied.

In Example 5A, a layer composed of molybdenum ruthenium oxynitride (MoRuON) as the C layer of the protection film was formed with using a molybdenum (Mo) target and a ruthenium (Ru) target, as targets, and argon gas (Ar gas), oxygen gas ($O_2$ gas) and nitrogen gas ($N_2$ gas), as sputtering gases, by performing sputtering of the molybdenum (Mo) target and the ruthenium (Ru) target, with adjusting applied powers to the targets and flow rates of the sputtering gases. Other than the C layer of the protection film, the same manner as in Example 1A was applied.

In Example 6A, a layer composed of niobium oxide (NbO) as the B layer of the protection film was formed with using a niobium (Nb) target as a target, and argon gas (Ar gas) and oxygen gas ($O_2$ gas), as sputtering gases, by performing sputtering of the niobium (Nb) target, with adjusting an applied power to the target and flow rates of the sputtering gases. Other than the B layer of the protection film, the same manner as in Example 1A was applied.

In Example 7A, a layer composed of niobium (Nb) as the B layer of the protection film was formed with using a niobium (Nb) target as a target, and argon gas (Ar gas) as a sputtering gas, by performing sputtering of the niobium (Nb) target, with adjusting an applied power to the target and a flow rate of the sputtering gas. Other than the B layer of the protection film, the same manner as in Example 1A was applied.

In Example 8A, a layer composed of niobium molybdenum (NbMo) as the B layer of the protection film was formed with using a niobium (Nb) target and a molybdenum (Mo) target, as targets, and argon gas (Ar gas) as a sputtering gas, by performing sputtering of the niobium (Nb) target and the molybdenum (Mo) target, with adjusting applied powers to the targets and a flow rate of the sputtering gas. Other than the B layer of the protection film, the same manner as in Example 1A was applied.

In Example 9A, a layer composed of niobium oxide (NbO) as the B layer of the protection film was formed in the same manner as in Example 6A. Further, a layer composed of rhodium ruthenium (RhRu) as the A layer of the protection film was formed with using a rhodium (Rh) target and a ruthenium (Ru) target, as targets, and argon gas (Ar gas) as a sputtering gas, by performing sputtering of the rhodium (Rh) target and the ruthenium (Ru) target, with adjusting applied powers to the targets and a flow rate of the sputtering gas. Other than the B layer and the A layer of the protection film, the same manner as in Example 1A was applied.

In Example 10A, a protection film constituted of five layers was formed. First, a layer composed of molybdenum (Mo) as the C layer was formed on the multilayer reflection film in the same manner as in Example 1A. Next, a layer composed of niobium ruthenium (NbRu) as the B layer was formed on the C layer in the same manner as in Example 1A. Next, a layer composed of molybdenum (Mo) as the C layer was formed on the B layer in the same manner as in Example 1A. Next, a layer composed of niobium ruthenium (NbRu) as the B layer was formed on the C layer in the same manner as in Example 1A. Next, a layer composed of rhodium (Rh) as the A layer was formed on the B layer in the same manner as in Example 1A. As a result, the protection film consisting of five layers of, from the side remote from the substrate, the A layer, the B layer, the C layer, the B layer and the C layer was formed. Other than the protection film, the same manner as in Example 1A was applied.

In Example 11A, a protection film constituted of five layers was formed. First, a layer composed of molybdenum (Mo) as the C layer was formed on the multilayer reflection film in the same manner as in Example 1A. Next, a layer composed of niobium oxide (NbO) as the B layer was formed on the C layer in the same manner as in Example 6A. Next, a layer composed of molybdenum (Mo) as the C layer was formed on the B layer in the same manner as in Example 1A. Next, a layer composed of niobium oxide (NbO) as the B layer was formed on the C layer in the same manner as in Example 6A. Next, a layer composed of rhodium (Rh) as the A layer was formed on the B layer in the same manner as in Example 1A. As a result, the protection film consisting of five layers of, from the side remote from the substrate, the A layer, the B layer, the C layer, the B layer and the C layer was formed. Other than the protection film, the same manner as in Example 1A was applied.

In Example 12A, a protection film constituted of five layers was formed. First, a layer composed of molybdenum (Mo) as the C layer was formed on the multilayer reflection film in the same manner as in Example 1A. Next, a layer composed of niobium ruthenium (NbRu) as the B layer was formed on the C layer in the same manner as in Example 1A. Next, a layer composed of molybdenum (Mo) as the C layer was formed on the B layer in the same manner as in Example 1A. Next, a layer composed of niobium oxide (NbO) as the B layer was formed on the C layer in the same manner as in Example 6A. Next, a layer composed of rhodium (Rh) as the A layer was formed on the B layer in the same manner as in Example 1A. As a result, the protection film consisting of five layers of, from the side remote from the substrate, the A layer, the B layer, the C layer, the B layer and the C layer was formed. Other than the protection film, the same manner as in Example 1A was applied.

In Example 13A, a protection film constituted of five layers was formed. First, a layer composed of molybdenum (Mo) as the C layer was formed on the multilayer reflection film in the same manner as in Example 1A. Next, a layer composed of niobium oxide (NbO) as the B layer was formed on the C layer in the same manner as in Example 6A. Next, a layer composed of molybdenum (Mo) as the C layer was formed on the B layer in the same manner as in Example 1A. Next, a layer composed of niobium ruthenium (NbRu) as the B layer was formed on the C layer in the same manner as in Example 1A. Next, a layer composed of rhodium (Rh) as the A layer was formed on the B layer in the same manner as in Example 1A. As a result, the protection film consisting of five layers of, from the side remote from the substrate, the A layer, the B layer, the C layer, the B layer and the C layer was formed. Other than the protection film, the same manner as in Example 1A was applied.

In Example 14A, a layer composed of ruthenium oxynitride (RuON) as the first layer of the hard mask film was formed with using a ruthenium (Ru) target as a target, and argon gas (Ar gas), oxygen gas ($O_2$ gas) and nitrogen gas ($N_2$ gas), as sputtering gases, by sputtering with adjusting an applied power to the target and flow rates of the sputtering gases. Other than the first layer of the hard mask film, the same manner as in Example 1A was applied.

In Example 15A, a layer composed of tantalum oxynitride (TaON) as the second layer of the hard mask film was formed with using a tantalum (Ta) target as a target, and argon gas (Ar gas), oxygen gas ($O_2$ gas) and nitrogen gas ($N_2$ gas), as sputtering gases, by sputtering with adjusting an applied power to the target and flow rates of the sputtering gases. Other than the second layer of the hard mask film, the same manner as in Example 1A was applied.

In Example 16A, a layer composed of ruthenium oxynitride (RuON) as the first layer of the hard mask film was formed in the same manner as in Example 14A. Further, a layer composed of tantalum oxynitride (TaON) as the second layer of the hard mask film was formed in the same manner as in Example 15A. Other than the first layer and the second layer of the hard mask film, the same manner as in Example 1A was applied.

In Example 17A, the second layer of the hard mask film was not formed. Other than the second layer of the hard mask film, the same manner as in Example 1A was applied.

In Comparative Example 1A, the C layer of the protection film was not formed. Further, instead of the C layer of the protection film, a layer composed of ruthenium (Ru) (Ru layer) was formed with using a ruthenium (Ru) target as a target, and argon gas (Ar gas) as a sputtering gas, by performing sputtering of the ruthenium (Ru) target, with adjusting an applied power to the target and a flow rate of the sputtering gas. Other than the C layer of the protection film, and the Ru layer, the same manner as in Example 1A was applied.

In Comparative Example 2A, the B layer and the C layer of the protection film were not formed. Further, instead of the C layer of the protection film, a layer composed of ruthenium (Ru) (Ru layer) was formed in the same manner as in Comparative Example 1A. Other than the B layer and the C layer of the protection film, and the Ru layer, the same manner as in Example 1A was applied.

In Comparative Example 3A, the B layer of the protection film was not formed. Other than the B layer of the protection film, the same manner as in Example 1A was applied.

In Comparative Example 4A, the C layer of the protection film was not formed. Other than the C layer of the protection film, the same manner as in Example 8A was applied.

In Comparative Example 5A, the C layer of the protection film was not formed. Other than the C layer of the protection film, the same manner as in Example 1A was applied.

In Comparative Example 6A, the B layer and the C layer of the protection film were not formed. Other than the B layer and the C layer of the protection film, the same manner as in Example 1A was applied.

In Comparative Example 7A, the B layer and the C layer of the protection film were not formed. Further, a layer composed of rhodium ruthenium (RhRu) as the A layer of the protection film was formed with using a rhodium (Rh) target and a ruthenium (Ru) target, as targets, and argon gas (Ar gas) as a sputtering gas, by performing sputtering of the rhodium (Rh) target and the ruthenium (Ru) target, with adjusting applied powers to the targets and a flow rate of the sputtering gas. Other than the protection film, the same manner as in Example 1A was applied.

In Comparative Example 8A, the B layer and the C layer of the protection film were not formed. Further, a layer composed of rhodium niobium ruthenium (RhNbRu) as the A layer of the protection film was formed with using a rhodium (Rh) target, a niobium (Nb) target and a ruthenium (Ru) target, as targets, and argon gas (Ar gas) as a sputtering gas, by performing sputtering of the rhodium (Rh) target, the niobium (Nb) target and the ruthenium (Ru) target, with adjusting applied powers to the targets and a flow rate of the sputtering gas. Other than the protection film, the same manner as in Example 1A was applied.

In Comparative Example 9A, the C layer of the protection film was not formed. Further, between the A layer and the B layer of the protection film, a layer composed of ruthenium (Ru) (Ru layer) was formed with using a ruthenium (Ru) target as a target, and argon gas (Ar gas) as a sputtering gas, by performing sputtering of the ruthenium (Ru) target, with adjusting an applied power to the target and a flow rate of the sputtering gas. Other than the C layer of the protection film, and the Ru layer, the same manner as in Example 1A was applied.

In connection with the protection film, the compositions and the thickness of each layer (the A layer, the B layer and the C layer), and the total thickness of the protection film, and the reflectance, which was a reflectance of the combination of the multilayer reflection film and protection film with respect to light having a wavelength of 13.5 nm, are shown in Table 1A or Table 1B. Further, in connection with the first layer and the second layer of the hard mask film, the compositions and the thicknesses are shown in Table 2.

Table 1A

| | | Protection film | | | | | | | | Reflectance [%] |
| | | Composition [at%] | | | | | | Thickness [nm] | | |
| | | Rh | Nb | Mo | Ru | O | N | Layer | Total | |
| Example 1A | A layer | 100 | 0 | 0 | 0 | 0 | 0 | 1.3 | 3.3 | 65.2 |
| | B layer | 0 | 17 | 0 | 83 | 0 | 0 | 1.0 | | |
| | C layer | 0 | 0 | 100 | 0 | 0 | 0 | 1.0 | | |
| Example 2A | A layer | 100 | 0 | 0 | 0 | 0 | 0 | 1.3 | 3.0 | 64.6 |
| | B layer | 0 | 17 | 0 | 83 | 0 | 0 | 1.0 | | |
| | C layer | 0 | 0 | 50 | 50 | 0 | 0 | 0.7 | | |
| Example 3A | A layer | 100 | 0 | 0 | 0 | 0 | 0 | 1.3 | 3.0 | 64.6 |
| | B layer | 0 | 17 | 0 | 83 | 0 | 0 | 1.0 | | |
| | C layer | 0 | 0 | 34 | 40 | 26 | 0 | 0.7 | | |
| Example 4A | A layer | 100 | 0 | 0 | 0 | 0 | 0 | 1.3 | 2.9 | 64.3 |
| | B layer | 0 | 17 | 0 | 83 | 0 | 0 | 1.0 | | |
| | C layer | 0 | 0 | 38 | 52 | 0 | 10 | 0.6 | | |
| Example 5A | A layer | 100 | 0 | 0 | 0 | 0 | 0 | 1.3 | 3.0 | 64.6 |
| | B layer | 0 | 17 | 0 | 83 | 0 | 0 | 1.0 | | |
| | C layer | 0 | 0 | 34 | 40 | 18 | 8 | 0.7 | | |
| Example 6A | A layer | 100 | 0 | 0 | 0 | 0 | 0 | 1.3 | 3.0 | 65.8 |
| | B layer | 0 | 80 | 0 | 0 | 20 | 0 | 0.7 | | |
| | C layer | 0 | 0 | 100 | 0 | 0 | 0 | 1.0 | | |
| Example 7A | A layer | 100 | 0 | 0 | 0 | 0 | 0 | 1.3 | 3.3 | 66.0 |
| | B layer | 0 | 100 | 0 | 0 | 0 | 0 | 1.0 | | |
| | C layer | 0 | 0 | 100 | 0 | 0 | 0 | 1.0 | | |

(continued)

| | | Protection film | | | | | | | | Reflectance [%] |
|---|---|---|---|---|---|---|---|---|---|---|
| | | Composition [at%] | | | | | | Thickness [nm] | | |
| | | Rh | Nb | Mo | Ru | O | N | Layer | Total | |
| Example 8A | A layer | 100 | 0 | 0 | 0 | 0 | 0 | 1.3 | 3.3 | 65.9 |
| | B layer | 0 | 50 | 50 | 0 | 0 | 0 | 1.0 | | |
| | C layer | 0 | 0 | 100 | 0 | 0 | 0 | 1.0 | | |
| Example 9A | A layer | 50 | 0 | 0 | 50 | 0 | 0 | 1.6 | 3.4 | 65.8 |
| | B layer | 0 | 80 | 0 | 0 | 20 | 0 | 0.8 | | |
| | C layer | 0 | 0 | 100 | 0 | 0 | 0 | 1.0 | | |
| Example 10A | A layer | 100 | 0 | 0 | 0 | 0 | 0 | 1.0 | 3.6 | 65.0 |
| | B layer | 0 | 17 | 0 | 83 | 0 | 0 | 0.6 | | |
| | C layer | 0 | 0 | 100 | 0 | 0 | 0 | 0.7 | | |
| | B layer | 0 | 17 | 0 | 83 | 0 | 0 | 0.6 | | |
| | C layer | 0 | 0 | 100 | 0 | 0 | 0 | 0.7 | | |
| Example 11A | A layer | 100 | 0 | 0 | 0 | 0 | 0 | 1.0 | 3.8 | 65.4 |
| | B layer | 0 | 80 | 0 | 0 | 20 | 0 | 0.7 | | |
| | C layer | 0 | 0 | 100 | 0 | 0 | 0 | 0.7 | | |
| | B layer | 0 | 80 | 0 | 0 | 20 | 0 | 0.7 | | |
| | C layer | 0 | 0 | 100 | 0 | 0 | 0 | 0.7 | | |

Table 1B

| | | Protection film | | | | | | | | Reflectance [%] |
|---|---|---|---|---|---|---|---|---|---|---|
| | | Composition [at%] | | | | | | Thickness [nm] | | |
| | | Rh | Nb | Mo | Ru | O | N | Layer | Total | |
| Example 12A | A layer | 100 | 0 | 0 | 0 | 0 | 0 | 1.0 | 3.7 | 65.2 |
| | B layer | 0 | 80 | 0 | 0 | 20 | 0 | 0.7 | | |
| | C layer | 0 | 0 | 100 | 0 | 0 | 0 | 0.7 | | |
| | B layer | 0 | 17 | 0 | 83 | 0 | 0 | 0.6 | | |
| | C layer | 0 | 0 | 100 | 0 | 0 | 0 | 0.7 | | |
| Example 13A | A layer | 100 | 0 | 0 | 0 | 0 | 0 | 1.0 | 3.7 | 65.2 |
| | B layer | 0 | 17 | 0 | 83 | 0 | 0 | 0.6 | | |
| | C layer | 0 | 0 | 100 | 0 | 0 | 0 | 0.7 | | |
| | B layer | 0 | 80 | 0 | 0 | 20 | 0 | 0.7 | | |
| | C layer | 0 | 0 | 100 | 0 | 0 | 0 | 0.7 | | |
| Example 14A | A layer | 100 | 0 | 0 | 0 | 0 | 0 | 2.0 | 4.0 | 64.4 |
| | B layer | 0 | 17 | 0 | 83 | 0 | 0 | 1.0 | | |
| | C layer | 0 | 0 | 100 | 0 | 0 | 0 | 1.0 | | |
| Example 15A | A layer | 100 | 0 | 0 | 0 | 0 | 0 | 1.3 | 3.3 | 65.2 |
| | B layer | 0 | 17 | 0 | 83 | 0 | 0 | 1.0 | | |
| | C layer | 0 | 0 | 100 | 0 | 0 | 0 | 1.0 | | |

(continued)

| | | Protection film | | | | | | | | Reflectance [%] |
| | | Composition [at%] | | | | | | Thickness [nm] | | |
| | | Rh | Nb | Mo | Ru | O | N | Layer | Total | |
|---|---|---|---|---|---|---|---|---|---|---|
| Example 16A | A layer | 100 | 0 | 0 | 0 | 0 | 0 | 2.0 | 4.0 | 64.4 |
| | B layer | 0 | 17 | 0 | 83 | 0 | 0 | 1.0 | | |
| | C layer | 0 | 0 | 100 | 0 | 0 | 0 | 1.0 | | |
| Example 17A | A layer | 100 | 0 | 0 | 0 | 0 | 0 | 1.3 | 3.3 | 65.2 |
| | B layer | 0 | 17 | 0 | 83 | 0 | 0 | 1.0 | | |
| | C layer | 0 | 0 | 100 | 0 | 0 | 0 | 1.0 | | |
| Comparative Example 1A | A layer | 100 | 0 | 0 | 0 | 0 | 0 | 1.3 | 3.3 | 63.9 |
| | B layer | 0 | 17 | 0 | 83 | 0 | 0 | 1.0 | | |
| | Ru layer | 0 | 0 | 0 | 100 | 0 | 0 | 1.0 | | |
| Comparative Example 2A | A layer | 100 | 0 | 0 | 0 | 0 | 0 | 1.5 | 3.0 | 64.3 |
| | Ru layer | 0 | 0 | 0 | 100 | 0 | 0 | 1.5 | | |
| Comparative Example 3A | A layer | 100 | 0 | 0 | 0 | 0 | 0 | 1.5 | 3.0 | 65.1 |
| | C layer | 0 | 0 | 100 | 0 | 0 | 0 | 1.5 | | |
| Comparative Example 4A | A layer | 100 | 0 | 0 | 0 | 0 | 0 | 1.5 | 3.0 | 64.9 |
| | B layer | 0 | 50 | 50 | 0 | 0 | 0 | 1.5 | | |
| Comparative Example 5A | A layer | 100 | 0 | 0 | 0 | 0 | 0 | 1.5 | 3.0 | 64.1 |
| | B layer | 0 | 17 | 0 | 83 | 0 | 0 | 1.5 | | |
| Comparative Example 6A | A layer | 100 | 0 | 0 | 0 | 0 | 0 | 3.0 | 3.0 | 63.5 |
| Comparative Example 7A | A layer | 80 | 0 | 0 | 20 | 0 | 0 | 3.0 | 3.0 | 63.8 |
| Comparative Example 8A | A layer | 70 | 10 | 0 | 20 | 0 | 0 | 3.0 | 3.0 | 64.0 |
| Comparative Example 9A | A layer | 100 | 0 | 0 | 0 | 0 | 0 | 1.0 | 3.0 | 63.8 |
| | Ru layer | 0 | 0 | 0 | 100 | 0 | 0 | 1.0 | | |
| | B layer | 0 | 17 | 0 | 83 | 0 | 0 | 1.0 | | |

## Table 2

| | | First Layer of Hard Mask Film | | | | | | Second Layer of Hard Mask Film | | | | |
| --- | --- | --- | --- | --- | --- | --- | --- | --- | --- | --- | --- | --- |
| | | Composition [at%] | | | | | Thickness [nm] | Composition [at%] | | | | Thickness [nm] |
| | | Cr | Ru | O | N | C | | Si | Ta | O | N | |
| Example | 1A | 38 | 0 | 34 | 18 | 10 | 10 | 32 | 0 | 66 | 2 | 10 |
| | 2A | 38 | 0 | 34 | 18 | 10 | 10 | 32 | 0 | 66 | 2 | 10 |
| | 3A | 38 | 0 | 34 | 18 | 10 | 10 | 32 | 0 | 66 | 2 | 10 |
| | 4A | 38 | 0 | 34 | 18 | 10 | 10 | 32 | 0 | 66 | 2 | 10 |
| | 5A | 38 | 0 | 34 | 18 | 10 | 10 | 32 | 0 | 66 | 2 | 10 |
| | 6A | 38 | 0 | 34 | 18 | 10 | 10 | 32 | 0 | 66 | 2 | 10 |
| | 7A | 38 | 0 | 34 | 18 | 10 | 10 | 32 | 0 | 66 | 2 | 10 |
| | 8A | 38 | 0 | 34 | 18 | 10 | 10 | 32 | 0 | 66 | 2 | 10 |
| | 9A | 38 | 0 | 34 | 18 | 10 | 10 | 32 | 0 | 66 | 2 | 10 |
| | 10A | 38 | 0 | 34 | 18 | 10 | 10 | 32 | 0 | 66 | 2 | 10 |
| | 11A | 38 | 0 | 34 | 18 | 10 | 10 | 32 | 0 | 66 | 2 | 10 |
| | 12A | 38 | 0 | 34 | 18 | 10 | 10 | 32 | 0 | 66 | 2 | 10 |
| | 13A | 38 | 0 | 34 | 18 | 10 | 10 | 32 | 0 | 66 | 2 | 10 |
| | 14A | 0 | 89 | 4 | 7 | 0 | 10 | 32 | 0 | 66 | 2 | 10 |
| | 15A | 38 | 0 | 34 | 18 | 10 | 10 | 0 | 40 | 20 | 40 | 10 |
| | 16A | 0 | 89 | 4 | 7 | 0 | 10 | 0 | 40 | 20 | 40 | 10 |
| | 17A | 38 | 0 | 34 | 18 | 10 | 10 | N/A | | | | |
| Comparative Example | 1A | 38 | 0 | 34 | 18 | 10 | 10 | 32 | 0 | 66 | 2 | 10 |
| | 2A | 38 | 0 | 34 | 18 | 10 | 10 | 32 | 0 | 66 | 2 | 10 |
| | 3A | 38 | 0 | 34 | 18 | 10 | 10 | 32 | 0 | 66 | 2 | 10 |
| | 4A | 38 | 0 | 34 | 18 | 10 | 10 | 32 | 0 | 66 | 2 | 10 |
| | 5A | 38 | 0 | 34 | 18 | 10 | 10 | 32 | 0 | 66 | 2 | 10 |
| | 6A | 38 | 0 | 34 | 18 | 10 | 10 | 32 | 0 | 66 | 2 | 10 |
| | 7A | 38 | 0 | 34 | 18 | 10 | 10 | 32 | 0 | 66 | 2 | 10 |
| | 8A | 38 | 0 | 34 | 18 | 10 | 10 | 32 | 0 | 66 | 2 | 10 |
| | 9A | 38 | 0 | 34 | 18 | 10 | 10 | 32 | 0 | 66 | 2 | 10 |

Examples 1B to 16B and Comparative Examples 1B to 9B

A reflective photomask was manufactured from each sample of the reflective photomask blanks obtained in Examples 1A to 16A and Comparative Examples 1A to 9A. First, a positive chemically amplified electron beam resist was spin-coated on the second layer of the hard mask film to form a resist film having a thickness of 60 nm.

Next, a line and space pattern (long side dimension: 1000 nm, short side dimension: 100 nm, 100000 line patterns ((line pattern width):(space pattern width)=1:1) was drawn at a dose of 100 $\mu$C/cm$^2$ by an electron beam lithography apparatus. Next, a heat treatment (PEB: Post Exposure Bake) was performed at 110° C for 14 minutes by a heat treatment apparatus. Next, a development process was performed for 40 seconds by paddle development to form a resist pattern.

Next, dry etching using a fluorine-based gas was performed to the second layer of the hard mask film for an etching time that was the total of the etching clear time and a time of 15% of the clear time for over etching under the following conditions (Condition 1) with using the obtained resist pattern as an etching mask, to form a pattern of the second layer of the hard mask film.

[Conditions for Dry Etching Using Fluorine-based Gas (Condition 1)]

Apparatus: ICP (Inductively Coupled Plasma) System
Gas: $SF_6$ gas and He gas
Gas pressure: 4.0 mTorr (0.53 Pa)
ICP power: 400W

Next, the remaining resist pattern was removed by washing with a sulfuric acid-hydrogen peroxide mixture (a mixture of sulfuric acid and hydrogen peroxide (sulfuric acid/hydrogen peroxide=3/1 (volume ratio))). The same method was applied to the removal of the resist pattern in the followings.
Next, dry etching using a chlorine-based gas was performed to the first layer of the hard mask film for an etching time that was the total of the etching clear time and a time of 300% of the clear time for over etching under the following conditions (Condition 2) with using the obtained pattern of the second layer of the hard mask film as an etching mask, to form a pattern of the first layer of the hard mask film.

[Conditions for Dry Etching Using Chlorine-based Gas (Condition 2)]

Apparatus: ICP (Inductively Coupled Plasma) System
Gas: $Cl_2$ gas and $O_2$ gas
Gas pressure: 3.0 mTorr (0.40 Pa)
ICP power: 350W

Next, dry etching using a fluorine-based gas was performed to the light absorbing film for an etching time that was the total of the etching clear time and a time of 15% of the clear time for over etching under the above-described conditions for the dry etching using a fluorine-based gas (Condition 1) with using the obtained pattern of the first layer of the hard mask film as an etching mask, to form a pattern of the light absorbing film, and the pattern of the second layer of the hard mask film was simultaneously removed.
Next, dry etching using a chlorine-based gas was performed to the pattern of the first layer of the hard mask film for an etching time that was the total of the etching clear time and a time of 100% of the clear time for over etching under the above-described conditions for the dry etching using a chlorine-based gas (Condition 2), to remove the pattern of the first layer of the hard mask film. As a result, the reflective photomask was obtained.

Example 17B

A reflective photomask was manufactured from a sample of the reflective photomask blank obtained in Example 15A. First, a positive chemically amplified electron beam resist was spin-coated on the first layer of the hard mask film to form a resist film having a thickness of 60 nm.
Next, in the same manner as in Example 1B, the line and space pattern was formed, and the heat treatment and the development process were performed to form a resist pattern.
Next, dry etching using a chlorine-based gas was performed to the first layer of the hard mask film for an etching time that was the total of the etching clear time and a time of 300% of the clear time for over etching under the above-described conditions for the dry etching using a chlorine-based gas (Condition 2) with using the obtained resist pattern as an etching mask, to form a pattern of the first layer of the hard mask film.
Next, the remaining resist pattern was removed by washing with a sulfuric acid-hydrogen peroxide mixture.
Next, dry etching using a fluorine-based gas was performed to the light absorbing film for an etching time that was the total of the etching clear time and a time of 15% of the clear time for over etching under the above-described conditions for the dry etching using a fluorine-based gas (Condition 1) with using the obtained pattern of the first layer of the hard mask film as an etching mask, to form a pattern of the light absorbing film.
Next, dry etching using a chlorine-based gas was performed to the pattern of the first layer of the hard mask film for an etching time that was the total of the etching clear time and a time of 100% of the clear time for over etching under the above-described conditions for the dry etching using a chlorine-based gas (Condition 2), to remove the pattern of the first layer of the hard mask film. As a result, the reflective photomask was obtained.

[Loss Amount of Protection Film in Manufacturing Reflective Photomask]

The protection film is exposed to over etching during dry etching using a fluorine-based gas when the light absorbing film is patterned, and to dry etching (including over etching) using a chlorine-based gas when the pattern of the first layer of hard mask film is removed. A whole thickness (remaining amount) of the protection film in the obtained reflective photomask was measured. The results are shown in Table 3.

[Evaluation of Resistance to Blister Defect in Reflective Photomask]

The obtained reflective photomask was irradiated with hydrogen plasma containing hydrogen ions for a predetermined time under the following conditions (Condition 3) by a hydrogen plasma generator. Then, the presence or absence of a blister defect was evaluated by a photomask visual inspection device. The results are shown in Table 3. The evaluation was performed at four irradiation times of 1 hour, 2 hours, 4 hours, and 8 hours, and terminated when a defect was detected.

[Conditions for Hydrogen Plasma Irradiation (Condition 3)]

Apparatus: Plasma enhanced Chemical Vapor Deposition (CVD) Apparatus
Chamber Pressure (at hydrogen gas ($H_2$ gas) introduced): 1 Torr (133 Pa)
Hydrogen Ion Flow Rate: $2 \times 10^{20}$ H·ions/$m^2$s
Plasma Source Power: 100W

<u>Table 3</u>

| | | Reflective Photomask Blank | Whole Thickness of Protection Film (Remaining Amount) [nm] | Tradition Time of Hydrogen Plasma /Blister Defect | | | |
|---|---|---|---|---|---|---|---|
| | | | | 1 Hour | 2 Hours | 4 Hours | 8 Hours |
| Example | 1B | 1A | 2.5 | N.D. | N.D. | N.D. | N.D. |
| | 2B | 2A | 2.2 | N.D. | N.D. | N.D. | N.D. |
| | 3B | 3A | 2.2 | N.D. | N.D. | N.D. | N.D. |
| | 4B | 4A | 2.1 | N.D. | N.D. | N.D. | N.D. |
| | 5B | 5A | 2.2 | N.D. | N.D. | N.D. | N.D. |
| | 6B | 6A | 2.2 | N.D. | N.D. | N.D. | N.D. |
| | 7B | 7A | 2.5 | N.D. | N.D. | N.D. | N.D. |
| | 8B | 8A | 2.5 | N.D. | N.D. | N.D. | N.D. |
| | 9B | 9A | 1.9 | N.D. | N.D. | N.D. | N.D. |
| | 10B | 10A | 2.8 | N.D. | N.D. | N.D. | N.D. |
| | 11B | 11A | 3.0 | N.D. | N.D. | N.D. | N.D. |
| | 12B | 12A | 2.9 | N.D. | N.D. | N.D. | N.D. |
| | 13B | 13A | 2.9 | N.D. | N.D. | N.D. | N.D. |
| | 14B | 14A | 2.3 | N.D. | N.D. | N.D. | N.D. |
| | 15B | 15A | 2.5 | N.D. | N.D. | N.D. | N.D. |
| | 16B | 16A | 2.3 | N.D. | N.D. | N.D. | N.D. |
| | 17B | 17A | 2.5 | N.D. | N.D. | N.D. | N.D. |
| Comparative Example | 1B | 1A | 2.5 | N.D. | N.D. | N.D. | N.D. |
| | 2B | 2A | 2.2 | N.D. | N.D. | Detected | - |
| | 3B | 3A | 2.2 | N.D. | N.D. | Detected | - |
| | 4B | 4A | 2.2 | N.D. | N.D. | Detected | - |
| | 5B | 5A | 2.2 | N.D. | N.D. | Detected | - |
| | 6B | 6A | 2.2 | Detected | - | - | - |
| | 7B | 7A | 2.2 | Detected | - | - | - |
| | 8B | 8A | 1.8 | Detected | - | - | - |
| | 9B | 9A | 2.2 | N.D. | N.D. | Detected | - |

The invention is not limited to the above embodiment. The above-described embodiment is an example, and any other embodiments having the same or substantially the same configuration as the technical idea of the invention and having the same or similar effects can be regarded as the invention included in the scope of the inventive technical range.

**Claims**

1. A reflective photomask comprising

a substrate,
a multilayer reflection film that is formed on the substrate and reflects exposure light being light in extreme ultraviolet range,

a protection film that is formed on and in contact with the multilayer reflection film to protect the multilayer reflection film, and
a pattern of a light absorbing film that is formed on and in contact with the protection film, and absorbs the exposure light, wherein

the protection film is constituted of multiple layers comprising one A layer, one or two or more B layers, and one or two or more C layers,
the A layer of the protection film comprises rhodium (Rh), and has a thickness of not less than 0.5 nm and not more than 2 nm,
the B layer of the protection film comprises niobium (Nb), is free of rhodium (Rh), has a niobium (Nb) content of not less than 10 at%, and has a thickness of not less than 0.5 nm and not more than 2 nm,
the C layer of the protection film comprises molybdenum (Mo), or molybdenum (Mo) and at least one selected from the group consisting of ruthenium (Ru), oxygen (O) and nitrogen (N), is free of rhodium (Rh) and niobium (Nb), has a molybdenum (Mo) content of not less than 30 at%, and has a thickness of not less than 0.5 nm and not more than 2 nm,
the A layer is in contact with the pattern of the light absorbing film, and
one layer of the C layer(s) is in contact with the multilayer reflection film.

2. The reflective photomask of claim 1 wherein the protection film is constituted of multiple layers consisting of the A layer, the B layer(s) and the C layer(s).

3. The reflective photomask of claim 2 wherein the protection film is constituted of multiple layers consisting of three layers of, from the side remote from the substrate, the A layer, the B layer and the C layer, or multiple layers consisting of five layers of, from the side remote from the substrate, the A layer, the B layer, the C layer, the B layer and the C layer.

4. The reflective photomask of any one of claims 1 to 3 wherein the light absorbing film is constituted of a single layer or multiple layers,

the single layer or each layer of the multiple layers is composed of a material that comprises ruthenium (Ru) and platinum (Pt), and has a ruthenium (Ru) content of not less than 30 at% and not more than 70 at%, a platinum (Pt) content of not less than 30 at% and not more than 70 at%, and a total content of ruthenium (Ru) and platinum (Pt) of not less than 96 at%,
the light absorbing film has a thickness of not less than 32 nm and not more than 38 nm, and
the light absorbing film has a reflectance of not less than 1% and not more than 8% with respect to the exposure light, and a phase shift of not less than 190 degrees and not more than 240 degrees with respect to the exposure light.

5. A reflective photomask blank comprising

a substrate,
a multilayer reflection film that is formed on the substrate and reflects exposure light being light in extreme ultraviolet range,
a protection film that is formed on and in contact with the multilayer reflection film to protect the multilayer reflection film,
a light absorbing film that is formed on and in contact with the protection film, and absorbs the exposure light, and
a hard mask film that is formed on and in contact with the light absorbing film, wherein

the protection film is constituted of multiple layers comprising one A layer, one or two or more B layers, and one or two or more C layers,
the A layer of the protection film comprises rhodium (Rh), and has a thickness of not less than 0.5 nm and not more than 2 nm,
the B layer of the protection film comprises niobium (Nb), is free of rhodium (Rh), has a niobium (Nb) content of not less than 10 at%, and has a thickness of not less than 0.5 nm and not more than 2 nm,
the C layer of the protection film comprises molybdenum (Mo), or molybdenum (Mo) and at least one selected from the group consisting of ruthenium (Ru), oxygen (O) and nitrogen (N), is free of rhodium (Rh) and niobium (Nb), has a molybdenum (Mo) content of not less than 30 at%, and has a thickness of not less than 0.5 nm and not more than 2 nm,
the A layer is in contact with the light absorbing film, and

one layer of the C layer(s) is in contact with the multilayer reflection film.

6. The reflective photomask blank of claim 5 wherein the protection film is constituted of multiple layers consisting of the A layer, the B layer(s) and the C layer(s).

7. The reflective photomask blank of claim 6 wherein the protection film is constituted of multiple layers consisting of three layers of, from the side remote from the substrate, the A layer, the B layer and the C layer, or multiple layers consisting of five layers of, from the side remote from the substrate, the A layer, the B layer, the C layer, the B layer and the C layer.

8. The reflective photomask blank of any one of claims 5 to 7 wherein the light absorbing film is constituted of a single layer or multiple layers,

the single layer or each layer of the multiple layers is composed of a material that comprises ruthenium (Ru) and platinum (Pt), and has a ruthenium (Ru) content of not less than 30 at% and not more than 70 at%, a platinum (Pt) content of not less than 30 at% and not more than 70 at%, and a total content of ruthenium (Ru) and platinum (Pt) of not less than 96 at%,
the light absorbing film has a thickness of not less than 32 nm and not more than 38 nm, and
the light absorbing film has a reflectance of not less than 1% and not more than 8% with respect to the exposure light, and a phase shift of not less than 190 degrees and not more than 240 degrees with respect to the exposure light.

9. The reflective photomask blank of any one of claims 5 to 8 wherein the hard mask film comprises a first layer that is in contact with the light absorbing film, and functions as an etching mask in patterning the light absorbing film by dry etching, and the first layer of the hard mask film is composed of a material that is resistant to dry etching using a fluorine-based gas, and is removal by dry etching using a chlorine-based gas.

10. The reflective photomask blank of claim 9 wherein the hard mask film comprises a second layer that is in contact with the first layer of the hard mask film, and functions as an etching mask in patterning the first layer of the hard mask film by dry etching, and the second layer of the hard mask film is composed of a material that is resistant to dry etching using a chlorine-based gas, and is removal by dry etching using a fluorine-based gas.

11. A method for manufacturing the reflective photomask of any one of claims 1 to 4 from the reflective photomask blank of claim 9 wherein
the method comprises the steps of:

(A1) forming a resist film in contact with the first layer of the hard mask film at the side remote from the substrate,
(B) patterning the resist film to form a resist pattern,
(C1) patterning the first layer of the hard mask film to form a pattern of the first layer of the hard mask film by dry etching using a chlorine-based gas and the resist pattern as an etching mask,
(D) removing the resist pattern,
(F1) patterning the light absorbing film to form a pattern of the light absorbing film by dry etching using a fluorine-based gas and the pattern of the first layer of the hard mask film as an etching mask, and
(G1) removing the pattern of the first layer of the hard mask film by dry etching using a chlorine-based gas.

12. A method for manufacturing the reflective photomask of any one of claims 1 to 4 from the reflective photomask blank of claim 10 wherein
the method comprises the steps of:

(A2) forming a resist film in contact with the second layer of the hard mask film at the side remote from the substrate,
(B) patterning the resist film to form a resist pattern,
(C2) patterning the second layer of the hard mask film to form a pattern of the second layer of the hard mask film by dry etching using a fluorine-based gas and the resist pattern as an etching mask,
(D) removing the resist pattern,
(E2) patterning the first layer of the hard mask film to form a pattern of the first layer of the hard mask film by dry etching using a chlorine-based gas and the pattern of the second layer of the hard mask film as an etching mask,
(F2) patterning the light absorbing film to form a pattern of the light absorbing film by dry etching using a fluorine-based gas and the pattern of the first layer of the hard mask film as an etching mask with removing the pattern of the second layer of the hard mask film, and

(G2) removing the pattern of the first layer of the hard mask film by dry etching using a chlorine-based gas.

# FIG.1

100
5(51)
4
31
32 } 3
33
2
1

# FIG.2

# FIG.3

# FIG.4

# FIG.5

300

4a
31
32 } 3
33

2

1

# FIG.6A

# FIG.6D

# FIG.6B

# FIG.6E

# FIG.6C

# FIG.6F

# FIG.7A

# FIG.7E

# FIG.7B

# FIG.7F

# FIG.7C

# FIG.7G

# FIG.7D

Europäisches
Patentamt

European
Patent Office

Office européen
des brevets

# EUROPEAN SEARCH REPORT

**Application Number**

EP 25 22 0891

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2024/241433 A1 (AKAGI DAIJIRO [JP] ET AL) 18 July 2024 (2024-07-18) * 55, 57-67, 93, 95-97, 114-124, 132-140; figures 2, 6; example 8 * | 1-12 | INV. G03F1/24 G03F1/32 G03F1/80 G03F1/48 |
| Y | US 2021/096456 A1 (SUZUKI KOTA [JP] ET AL) 1 April 2021 (2021-04-01) * 46-135; figures 2, 8F * | 1-12 | |
| Y | US 2024/160096 A1 (NAGATA YUYA [JP] ET AL) 16 May 2024 (2024-05-16) * 20-142; figure 2 * | 1-12 | |
| Y | US 2021/157226 A1 (KIM HO YEON [KR] ET AL) 27 May 2021 (2021-05-27) * 26-56, 65-71 and 100-102; figures 1, 4 * | 1-12 | |
| A | US 2024/134266 A1 (LIN YUN-YUE [TW]) 25 April 2024 (2024-04-25) * 32 * | 4,8 | TECHNICAL FIELDS SEARCHED (IPC) G03F |
| Y | JP 2024 081687 A (HOYA CORP) 18 June 2024 (2024-06-18) * 68-122 * | 10,12 | |

The present search report has been drawn up for all claims

| Place of search | Date of completion of the search | Examiner |
|---|---|---|
| Munich | 30 April 2026 | Brächer, Thomas |

EPO FORM 1503 03.82 (P4C01)

## ANNEX TO THE EUROPEAN SEARCH REPORT
## ON EUROPEAN PATENT APPLICATION NO.

EP 25 22 0891

This annex lists the patent family members relating to the patent documents cited in  the above-mentioned European search report.
The members are as contained in the European Patent Office EDP file on
The European Patent Office is in no way liable for these particulars which are merely given for the purpose of information.

30-04-2026

| Patent document cited in search report | | | Publication date | Patent family member(s) | | Publication date |
|---|---|---|---|---|---|---|
| US 2024241433 | A1 | | 18-07-2024 | JP | 7456562 B1 | 27-03-2024 |
| | | | | JP | 2024063124 A | 10-05-2024 |
| | | | | JP | 2026069718 A | 23-04-2026 |
| | | | | JP | WO2024024513 A1 | 01-02-2024 |
| | | | | KR | 20240032155 A | 08-03-2024 |
| | | | | KR | 20240132531 A | 03-09-2024 |
| | | | | TW | 202405551 A | 01-02-2024 |
| | | | | TW | 202441280 A | 16-10-2024 |
| | | | | US | 2024241433 A1 | 18-07-2024 |
| | | | | US | 2025004360 A1 | 02-01-2025 |
| | | | | WO | 2024024513 A1 | 01-02-2024 |
| US 2021096456 | A1 | | 01-04-2021 | NONE | | |
| US 2024160096 | A1 | | 16-05-2024 | JP | 7416342 B1 | 17-01-2024 |
| | | | | JP | 2024024684 A | 22-02-2024 |
| | | | | JP | WO2024009819 A1 | 11-01-2024 |
| | | | | KR | 20240024293 A | 23-02-2024 |
| | | | | TW | 202403434 A | 16-01-2024 |
| | | | | TW | 202447328 A | 01-12-2024 |
| | | | | US | 2024160096 A1 | 16-05-2024 |
| | | | | US | 2025155792 A1 | 15-05-2025 |
| | | | | WO | 2024009819 A1 | 11-01-2024 |
| US 2021157226 | A1 | | 27-05-2021 | CN | 109946919 A | 28-06-2019 |
| | | | | DE | 102018121550 A1 | 27-06-2019 |
| | | | | JP | 2019113825 A | 11-07-2019 |
| | | | | KR | 20190075339 A | 01-07-2019 |
| | | | | US | 2019196321 A1 | 27-06-2019 |
| | | | | US | 2021157226 A1 | 27-05-2021 |
| US 2024134266 | A1 | | 25-04-2024 | CN | 113359383 A | 07-09-2021 |
| | | | | TW | 202201113 A | 01-01-2022 |
| | | | | US | 2021397075 A1 | 23-12-2021 |
| | | | | US | 2023071118 A1 | 09-03-2023 |
| | | | | US | 2024134266 A1 | 25-04-2024 |
| | | | | US | 2025264793 A1 | 21-08-2025 |
| JP 2024081687 | A | | 18-06-2024 | JP | 7459399 B1 | 01-04-2024 |
| | | | | JP | 2024081687 A | 18-06-2024 |
| | | | | JP | WO2024048387 A1 | 07-03-2024 |
| | | | | KR | 20250053862 A | 22-04-2025 |
| | | | | TW | 202424634 A | 16-06-2024 |
| | | | | WO | 2024048387 A1 | 07-03-2024 |

EPO FORM P0459

For more details about this annex : see Official Journal of the European Patent Office, No. 12/82

**REFERENCES CITED IN THE DESCRIPTION**

**Patent documents cited in the description**

- JP 2022024617 A
- JP 2023086742 A
- WO 2023127799 A1